# EUROPEAN PATENT APPLICATION

(11) **EP 4 661 215 A1**
(43) Date of publication of application: **10.12.2025**
(21) Application number: 24793969.7
(22) Date of filing: 22.10.2024
(51) Int. Cl.: H01Q 21/24, H01Q 5/307, H01Q 1/24, H04M 1/02, G09G 3/20, H01Q 1/22, H10K 59/131

(54) **ELECTRONIC DEVICE COMPRISING ANTENNA**

(30) Priority: 09.04.2024 KR 20240047834; 20.05.2024 KR 20240065065
(71) Applicant: Samsung Electronics Co., Ltd, Suwon-si, Gyeonggi-do 16677 (KR)
(72) Inventor: CHO, Woosik, Suwon-si, Gyeonggi-do 16677 (KR); LEE, Gwanhui, Suwon-si, Gyeonggi-do 16677 (KR); KIM, Sanguk, Suwon-si, Gyeonggi-do 16677 (KR); PARK, Sungchul, Suwon-si, Gyeonggi-do 16677 (KR); SHIN, Seungshik, Suwon-si, Gyeonggi-do 16677 (KR); YE, Sangmin, Suwon-si, Gyeonggi-do 16677 (KR); LEE, Hanyeop, Suwon-si, Gyeonggi-do 16677 (KR)
(74) Representative: HGF
(86) International application number: PCT/KR2024/016089
(87) International publication number: WO 2025/216373

(57) **Abstract**

According to an embodiment of the disclosure, an electronic device includes a wireless communication circuit accommodated in the electronic device, a display accommodated in the electronic device, and including an active display area including a plurality of pixels, wherein at least one first active area of the active display area includes at least one first control line configured to drive some of the plurality pixels and extending along a first direction while not including at least one second control line extending along a second direction substantially perpendicular to the first direction, and an antenna radiator disposed under the display to at least partially overlap the at least one first active area and operatively connected to the wireless communication circuit. In an embodiment, the antenna radiator may be configured to radiate signals substantially through the at least one first active area in a second polarization corresponding to the second direction rather than in a first polarization corresponding to the first direction. In an embodiment, signals being radiated in the second polarization may correspond to signals received from the wireless communication circuit. Various other embodiments may be possible.

## Description

### [Technical Field]

Embodiment(s) of the disclosure relate to an electronic device, for example, an electronic device including an antenna.

### [Background Art]

With the development of electronic, information, or communication technology, various functions are being included in a single electronic device. For example, a smartphone may include functions of a sound playback device, an imaging device, or a digital diary, in addition to a communication function, and more diverse functions may be implemented in a smartphone through installation of additional applications. An electronic device may be provided with various pieces of information in real time by accessing a server or another electronic device in a wired or wireless manner as well as by executing an installed application or a stored file.

As various functions are implemented in single electronic devices (e.g., smartphones), electronic devices such as sound playback devices performing a specific function have already been replaced by smartphones, and the areas of video playback devices or imaging devices are also gradually being replaced by smartphones. As the use of electronic devices such as mobile communication terminals and smartphones becomes commonplace, various wireless communications based on different protocols may be implemented in a single electronic device. For example, various types of wireless communication functions, such as cellular communication, short-range/near-field wireless communication, or global navigation satellite system (GNSS) communication, may be integrated into a single electronic device. As the performance of such wireless communications continues to advance, the use of electronic devices may become more convenient.

The above-described information may be provided as related art for the purpose of assisting in understanding the disclosure. None of the above contents make an assertion or decision as to whether any of the above might be applicable as prior art with regard to the disclosure.

### [Detailed Description of the Invention]

### [Technical Solution]

According to an embodiment of the disclosure, an electronic device may include a wireless communication circuit accommodated in the electronic device, a display accommodated in the electronic device and including an active display area including a plurality of pixels, wherein the active display area at least partially includes an area (hereinafter, referred to as a 'first active area') including at least one first control line configured to drive some of the plurality pixels and extending along a first direction while not including at least one second control line extending along a second direction substantially perpendicular to the first direction, and an antenna radiator disposed at least partially disposed in the first active area of the display and operatively connected to the wireless communication circuit. In an embodiment, the antenna radiator may be configured to radiate signals, received from the wireless communication circuit, substantially through the first active area in a second polarization corresponding to the second direction rather than in a first polarization corresponding to the first direction.

According to an embodiment of the disclosure, an electronic device may include a wireless communication circuit accommodated in the electronic device, a display accommodated in the electronic device, and including an active display area including a plurality of pixels, wherein at least one first active area of the active display area includes at least one first control line configured to drive some of the plurality pixels and extending along a first direction while not including at least one second control line extending along a second direction substantially perpendicular to the first direction, and an antenna radiator disposed under the display to at least partially overlap the at least one first active area and operatively connected to the wireless communication circuit. In an embodiment, the antenna radiator may be configured to radiate signals substantially through the at least one first active area in a second polarization corresponding to the second direction rather than in a first polarization corresponding to the first direction. In an embodiment, signals being radiated in the second polarization may correspond to signals received from the wireless communication circuit.

According to an embodiment of the disclosure, the electronic device may include a housing, a wireless communication circuit accommodated in the housing, a display accommodated in the housing, and an antenna radiator disposed under the display to at least partially overlap the at least one first active area and operatively connected to the wireless communication circuit. In an embodiment, the display may include first control lines corresponding to at least a portion of a plurality of pixels and extending along a first direction, second control lines corresponding to at least some of the plurality of pixels and extending along a second direction intersecting the first direction, and at least one first active area in which some of the first control lines are arranged but the second control lines are not arranged. In an embodiment, the antenna radiator may be configured to radiate signals, received from the wireless communication circuit, substantially through the at least one first active area in a second polarization corresponding to the second direction rather than in a first polarization corresponding to the first direction.

According to an embodiment of the disclosure, the electronic device may include a wireless communication circuit, a display, and an antenna radiator disposed under the display to at least partially overlap the at least one first active area and operatively connected to the wireless communication circuit. In an embodiment, the display may include first control lines corresponding to at least a portion of a plurality of pixels and extending along a first direction, second control lines corresponding to at least some of the plurality of pixels and extending along a second direction intersecting the first direction, at least one first active area in which the first control lines are arranged but the second control lines are not arranged, and a second active area in which the first control lines and the second control lines are arranged together. In an embodiment, the antenna radiator may be configured to receive a signal from the wireless communication circuit and to transmit and receive a wireless signal having a polarization component that penetrates the at least one first active area.

According to an embodiment of the disclosure, an electronic device may comprise: a wireless communication circuit; a display including first pixel control lines extending in a first direction, second pixel control lines extending in a second direction intersecting the first direction, at least one first active area comprising a first set of pixels, and a second active area comprising a second set of pixels; and an antenna radiator disposed under the display to at least partially overlap the at least one first active area and operatively connected to the wireless communication circuit. In an embodiment at least one of the first pixel control lines is arranged in the at least one first active area but none of the second pixel control lines are arranged in the at least one first active area. In an embodiment, at least one of the first pixel control lines is arranged in the second active area and at least one of the second pixel control lines is arranged in the second active area. In an embodiment the antenna radiator is configured to receive signals from the wireless communication circuit and to transmit and/or receive wireless signals with a polarization component passing through the at least one first active area.

### [Brief Description of Drawings]

The above and other aspects, features, and/or advantages of an embodiment of the disclosure will be more apparent from the following detailed description taken in conjunction with the accompanying drawings.
FIG. 1 is a block diagram illustrating an electronic device according to an embodiment of the disclosure within a network environment.
FIG. 2 is a front perspective view of an electronic device according to an embodiment of the disclosure.
FIG. 3 is a rear perspective view of the electronic device according to an embodiment of the disclosure illustrated in FIG. 2.
FIG. 4 is an exploded perspective view illustrating the front side of an electronic device according to one embodiment of the present disclosure.
FIG. 5 is an exploded perspective view illustrating the rear side of an electronic device according to one embodiment of the present disclosure.
FIG. 6 is a view illustrating the arrangement of an antenna under a display of an electronic device according to an embodiment of the disclosure.
FIG. 7 is a cross-sectional view illustrating the arrangement of an antenna in an electronic device according to an embodiment of the disclosure, in which a cross-sectional view of the display and/or the antenna taken along line A-A' of FIG. 6 is illustrated.
FIG. 8 is a view illustrating a display of an electronic device according to an embodiment of the disclosure.
FIG. 9 is a view illustrating a display of an electronic device according to an embodiment of the disclosure.
FIG. 10 is a view to be referred to describe the arrangement of control lines in a display of an electronic device according to an embodiment of the disclosure.
FIG. 11 is a view to be referred to describe the arrangement of control lines in a display of an electronic device according to an embodiment of the disclosure.
FIG. 12 is a view to be referred when describing an electronic device according to an embodiment of the disclosure.
FIG. 13 is a view to be referred to describe an electronic device according to an embodiment of the disclosure.
FIG. 14 is a view to be referred to describe an electronic device according to an embodiment of the disclosure, illustrating an enlarged view of the portion 'E1' in FIG. 13.
FIG. 15 is a view illustrating an electronic device according to an embodiment of the disclosure.
FIG. 16 is a view illustrating an electronic device according to an embodiment of the disclosure.
FIG. 17 is a view illustrating the state in which a second display area of a display according to an embodiment of the disclosure is accommodated in a second housing.
FIG. 18 is a view illustrating the state in which the second display area of the display according to an embodiment of the disclosure is exposed to the outside of the second housing.
FIG. 19 is a view illustrating the arrangement of an antenna under a display of an electronic device according to an embodiment of the disclosure.
FIG. 20 is a view illustrating the arrangement of an antenna under a display of an electronic device according to an embodiment of the disclosure.
FIG. 21 is a view illustrating the arrangement of an antenna in an electronic device according to an embodiment of the disclosure.
Throughout the appended drawings, like reference numerals may be assigned to like components, configurations, and/or structures.

### [Mode for Carrying out the Invention]

Multiple antennas complying with different communication protocols have already been integrated into a single electronic device, and recently, wireless communication utilizing millimeter waves (mmWaves) has been commercialized. It is expected that the frequency bands used in commercial communication networks will become more diverse, and therefore, it is expected that there will be significant difficulties in securing space for installing antennas within the allowable inner space of electronic devices while maintaining portability. For example, in an environment where a display acts as an obstacle during wireless communication, it may be difficult to secure a location or space within an electronic device for antennas that create a stable wireless communication environment.

An embodiment of the disclosure is intended to resolve at least the above-described problems and/or disadvantages and to provide at least the advantages described below. An embodiment of the disclosure may provide an antenna capable of performing wireless communication through a display and/or an electronic device including the same.

An embodiment of the disclosure may provide an electronic device with improved design freedom in the arrangement of antennas.

The technical subjects pursued in the disclosure may not be limited to the above-mentioned technical subjects, and other technical subjects which are not mentioned may be clearly understood from the following descriptions by those skilled in the art to which the disclosure pertains.

The following description made with reference to the accompanying drawings may be provided in order to help a comprehensive understanding of various implementations of the disclosure defined by the claims and equivalents thereof. An exemplary embodiment set forth in the following description includes various particular details to help the understanding, but is considered one of various embodiments. Therefore, it will be apparent to those skilled in the art that various changes and modifications may be made to various implementations described herein without departing from the scope and technical idea of the disclosure. In addition, descriptions of well-known functions and configurations may be omitted for clarity and brevity.

The terms and words used in the following description and claims are not limited to bibliographical meanings, but may be used to clearly and consistently describe the various embodiments set forth herein. Therefore, it will be apparent to those skilled in the art that the following description of various implementations of the disclosure is provided only for the purpose of explanation, rather than for the purpose of limiting the disclosure defined as the scope of protection and equivalents thereto.

It should be appreciated that a singular form such as "a," "an," or "the" also includes the meaning as a plural form, unless the context clearly indicates otherwise. Therefore, for example, "a component surface" may mean one or more of component surfaces.

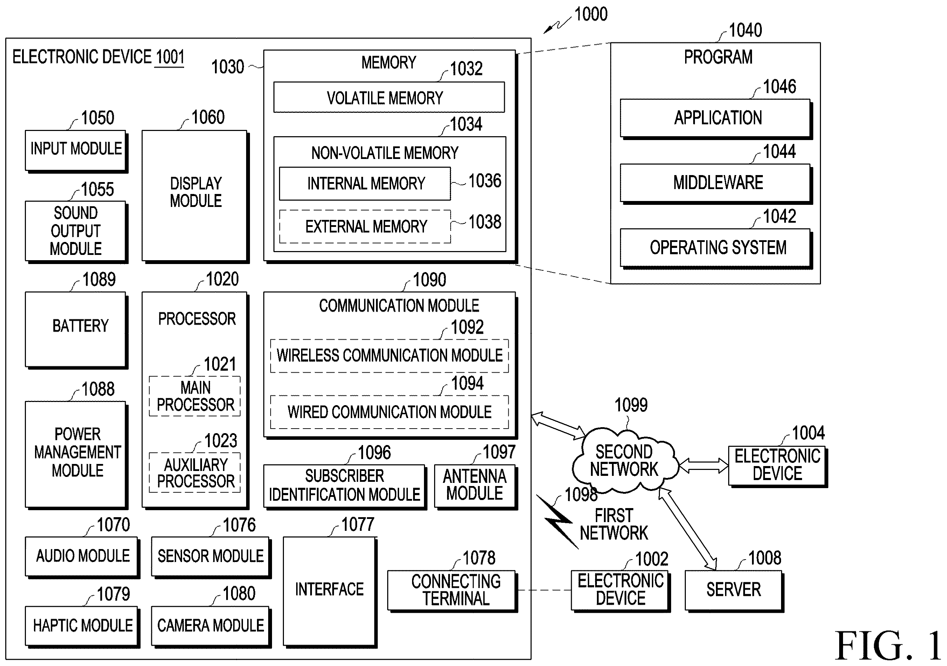

FIG. 1 is a block diagram illustrating an electronic device 1001 in a network environment 1000 according to various embodiments. Referring to FIG. 1, the electronic device 1001 in the network environment 1000 may communicate with an electronic device 1002 via a first network 1098 (e.g., a short-range wireless communication network), or at least one of an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input module 1050, a sound output module 1055, a display module 1060, an audio module 1070, a sensor module 1076, an interface 1077, a connecting terminal 1078, a haptic module 1079, a camera module 1080, a power management module 1088, a battery 1089, a communication module 1090, a subscriber identification module (SIM) 1096, or an antenna module 1097. In some embodiments, at least one of the components (e.g., the connecting terminal 1078) may be omitted from the electronic device 1001, or one or more other components may be added in the electronic device 1001. In some embodiments, some of the components (e.g., the sensor module 1076, the camera module 1080, or the antenna module 1097) may be implemented as a single component (e.g., the display module 1060).

The processor 1020 may execute, for example, software (e.g., a program 1040) to control at least one other component (e.g., a hardware or software component) of the electronic device 1001 coupled with the processor 1020, and may perform various data processing or computation. According to one embodiment, as at least part of the data processing or computation, the processor 1020 may store a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), or an auxiliary processor 1023 (e.g., a graphics processing unit (GPU), a neural processing unit (NPU), an image signal processor (ISP), a sensor hub processor, or a communication processor (CP)) that is operable independently from, or in conjunction with, the main processor 1021. For example, when the electronic device 1001 includes the main processor 1021 and the auxiliary processor 1023, the auxiliary processor 1023 may be adapted to consume less power than the main processor 1021, or to be specific to a specified function. The auxiliary processor 1023 may be implemented as separate from, or as part of the main processor 1021.

The auxiliary processor 1023 may control at least some of functions or states related to at least one component (e.g., the display module 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 1023. According to an embodiment, the auxiliary processor 1023 (e.g., the neural processing unit) may include a hardware structure specified for artificial intelligence model processing. An artificial intelligence model may be generated by machine learning. Such learning may be performed, e.g., by the electronic device 1001 where the artificial intelligence is performed or via a separate server (e.g., the server 1008). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input module 1050 may receive a command or data to be used by another component (e.g., the processor 1020) of the electronic device 1001, from the outside (e.g., a user) of the electronic device 1001. The input module 1050 may include, for example, a microphone, a mouse, a keyboard, a key (e.g., a button), or a digital pen (e.g., a stylus pen).

The sound output module 1055 may output sound signals to the outside of the electronic device 1001. The sound output module 1055 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1060 may visually provide information to the outside (e.g., a user) of the electronic device 1001. The display module 1060 may include, for example, a display, a hologram device, or a projector and control circuitry to control a corresponding one of the display, hologram device, and projector. According to an embodiment, the display module 1060 may include a touch sensor adapted to detect a touch, or a pressure sensor adapted to measure the intensity of force incurred by the touch.

The audio module 1070 may convert a sound into an electrical signal and vice versa. According to an embodiment, the audio module 1070 may obtain the sound via the input module 1050, or output the sound via the sound output module 1055 or a headphone of an external electronic device (e.g., an electronic device 1002) directly (e.g., wiredly) or wirelessly coupled with the electronic device 1001.

The sensor module 1076 may detect an operational state (e.g., power or temperature) of the electronic device 1001 or an environmental state (e.g., a state of a user) external to the electronic device 1001, and then generate an electrical signal or data value corresponding to the detected state. According to an embodiment, the sensor module 1076 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, a HDMI connector, a USB connector, a SD card connector, or an audio connector (e.g., a headphone connector).

The haptic module 1079 may convert an electrical signal into a mechanical stimulus (e.g., a vibration or a movement) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to one embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wired) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via the first network 1098 (e.g., a short-range communication network, such as BluetoothTM, wireless-fidelity (Wi-Fi) direct, or infrared data association (IrDA)) or the second network 1099 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1092 may identify and authenticate the electronic device 1001 in a communication network, such as the first network 1098 or the second network 1099, using subscriber information (e.g., international mobile subscriber identity (IMSI)) stored in the subscriber identification module 1096.

The wireless communication module 1092 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1092 may support a high-frequency band (e.g., the mmWave band) to achieve, e.g., a high data transmission rate. The wireless communication module 1092 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1092 may support various requirements specified in the electronic device 1001, an external electronic device (e.g., the electronic device 1004), or a network system (e.g., the second network 1099). According to an embodiment, the wireless communication module 1092 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1097 may transmit or receive a signal or power to or from the outside (e.g., the external electronic device) of the electronic device 1001. According to an embodiment, the antenna module may include an antenna including a radiating element composed of a conductive material or a conductive pattern formed in or on a substrate (e.g., a printed circuit board (PCB)). According to an embodiment, the antenna module 1097 may include a plurality of antennas (e.g., array antennas). In such a case, at least one antenna appropriate for a communication scheme used in the communication network, such as the first network 1098 or the second network 1099, may be selected, for example, by the communication module 1090 (e.g., the wireless communication module 1092) from the plurality of antennas. The signal or the power may then be transmitted or received between the communication module 1090 and the external electronic device via the selected at least one antenna. According to an embodiment, another component (e.g., a radio frequency integrated circuit (RFIC)) other than the radiating element may be additionally formed as part of the antenna module 1097.

According to various embodiments, the antenna module 1097 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1001 and the external electronic device 1004 via the server 1008 coupled with the second network 1099. Each of the electronic devices 1002 or 1004 may be a device of a same type as, or a different type, from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, mobile edge computing (MEC), or client-server computing technology may be used, for example. The electronic device 1001 may provide ultra low-latency services using, e.g., distributed computing or mobile edge computing. In another embodiment, the external electronic device 1004 may include an internet-of-things (IoT) device. The server 1008 may be an intelligent server using machine learning and/or a neural network. According to an embodiment, the external electronic device 1004 or the server 1008 may be included in the second network 1099. The electronic device 1001 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory ) that is readable by a machine (e.g., the electronic device ). For example, a processor (e.g., the processor ) of the machine (e.g., the electronic device ) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

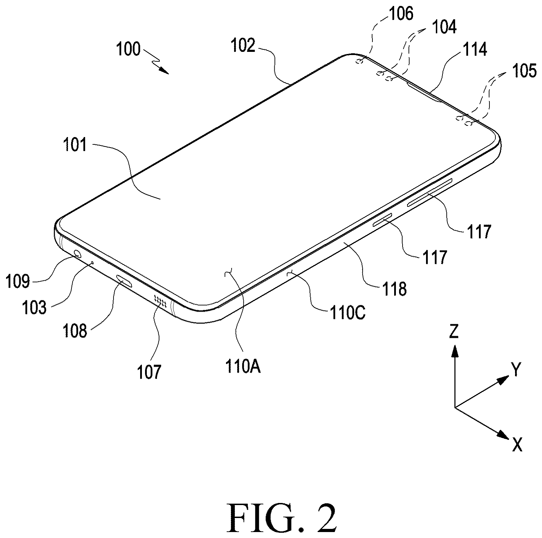

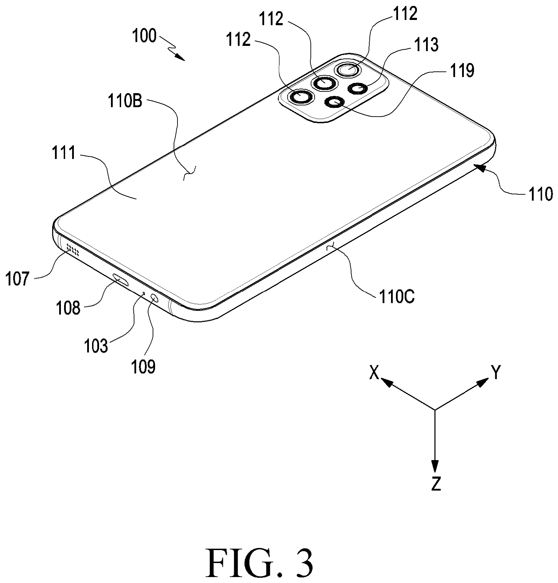

FIG. 2 is a front perspective view of an electronic device 100 according to an embodiment of the disclosure. FIG. 3 is a rear perspective view of the electronic device 100 of FIG. 2 according to an embodiment of the disclosure.

Referring to FIGS. 2 and 3, the electronic device 100 (e.g., the electronic device 1001 in FIG. 1) according to an embodiment may include a housing 110 including a first surface (or the front surface) 110A, a second surface (or the rear surface) 110B, and a side surface 110C surrounding the space between the first surface 110A and the second surface 110B. In an embodiment (not illustrated), the housing 110 may refer to a structure that forms some of the first surface 110A of FIG. 2, and the second surface 110B and the side surface 110C of FIG. 3. According to an embodiment, at least a portion of the first surface 110A may be formed of a substantially transparent front surface plate 102 (e.g., a glass plate or a polymer plate including various coating layers). The second surface 110B may be formed of a substantially opaque rear surface plate 111. The rear surface plate 111 may be made of, for example, coated or colored glass, ceramic, polymer, metal (e.g., aluminum, stainless steel (STS), or magnesium), or a combination of two or more of these materials. The side surface 110C may be defined by the side surface structure (or a "side surface bezel structure") 118 coupled to the front surface plate 102 and the rear surface plate 111 and including metal and/or polymer. In an embodiment, the rear surface plate 111 and the side surface structure 118 may be integrated with each other and may include the same material (e.g., a metal material such as aluminum).

Although not illustrated, the front surface plate 102 may include one or more areas that are curved and extend seamlessly from at least a portion of an edge toward the rear surface plate 111. In an embodiment, the front surface plate 102 (or the rear surface plate 111) may include only one of the areas bent and extending toward the rear surface plate 111 (or the front surface plate 102), at one side edge of the first surface 110A. According to an embodiment, the front surface plate 102 or the rear surface plate 111 may be substantially flat in shape. For example, the front or rear surface plate may not include an area that is curved and extended. When the bent and extending area is included, the thickness of the electronic device 100 in the portion including the bent and extending area may be smaller than the thicknesses of other portions.

According to an embodiment, the electronic device 100 may include at least one of a display 101, an audio module (e.g., a microphone hole 103, an external speaker hole 107, and a call receiver hole 114), a sensor module (e.g., a first sensor module 104, a second sensor module (not illustrated), and a third sensor module 119), a camera module (e.g., a first camera device 105, a second camera device 112, and a flash 113), key input devices 117, a light-emitting element 106, and connector holes (e.g., a first connector hole 108 and a second connector hole 109). In an embodiment, in the electronic device 100, at least one of the components (e.g., the key input devices 117 or the light-emitting element 106) may be omitted, or other components may be additionally included.

The display 101 may output a screen or may be visually exposed through, for example, a significant portion of the first surface 110A (e.g., the front surface plate 102). In an embodiment, at least a portion of the display 101 may be visually exposed through the front surface plate 102 forming the first surface 110A or through a portion of the side surface 110C. In an embodiment, the edges of the display 101 may be formed to be substantially the same as the shape of the periphery of the front surface plate 102 adjacent thereto. In an embodiment (not illustrated), the distance between the periphery of the display 101 and the periphery of the front surface plate 102 may be substantially constant in order to enlarge the visually exposed area of the display 101.

In an embodiment (not illustrated), recesses or openings may be provided in some portions of the screen display area of the display 101, and one or more of an audio module (e.g., the call receiver hole 114), a sensor module (e.g., the first sensor module 104), a camera module (e.g., the first camera module 105), and a light-emitting element 106 may be aligned with the recesses or the openings. In an embodiment (not illustrated), the rear surface of the screen display area of the display 101 may include at least one of an audio module (e.g., the call receiver hole 114), a sensor module (e.g., the first sensor module 104), a camera module (e.g., the first camera device 105), a fingerprint sensor (not illustrated), and a light-emitting element 106. In an embodiment (not illustrated), the display 101 may be coupled to or arranged adjacent to a touch-sensitive circuit, a pressure sensor capable of measuring a touch intensity (pressure), and/or a digitizer configured to detect an electromagnetic field-type stylus pen. In an embodiment, when the front surface plate 102 or the rear surface plate 111 includes one or more curved and extended areas, at least some of the sensor modules (e.g., the first sensor module 104 and the third sensor module 119), and/or at least some of the key input devices 117 may be arranged in the one or more curved and extended areas.

The audio module 103, 107, and 114 may include a microphone hole 103 and speaker holes (e.g., the external speaker hole 107 and the call receiver hole 114). A microphone configured to acquire external sound may be placed inside the microphone hole 103, and in an embodiment, a plurality of microphones may be placed to detect the direction of sound. The speaker holes may include an external speaker hole 107 and a call receiver hole 114. In an embodiment, the speaker holes (e.g., the external speaker hole 107 and the call receiver hole 114) and the microphone hole 103 may be implemented as a single hole, or a speaker may be included without the speaker holes (e.g., the external speaker hole 107 and the call receiver hole 114) (e.g., a piezo speaker).

The sensor modules may generate electrical signals or data values corresponding to the internal operating states or the external environmental states of the electronic device 100. The sensor modules may include, for example, a first sensor module 104 (e.g., a proximity sensor) and/or a second sensor module (not illustrated) (e.g., a fingerprint sensor) disposed on the first surface 110A of the housing 110, and/or a third sensor module 119 disposed on the second surface 110B of the housing 110. The second sensor module (not illustrated) (e.g., a fingerprint sensor) may be disposed not only on the first surface 110A (e.g., the display 101) of the housing 110, but also on the second surface 110B or the side surface 110C of the housing 110. The electronic device 100 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules may include a first camera device 105 disposed on the first surface 110A of the electronic device 100, and a second camera device 112 and/or a flash 113 disposed on the second surface 110B of the electronic device 100. The camera devices (e.g., the first camera device 105 and the second camera device 112) may include one or more lenses, an image sensor, and/or an image signal processor. The flash 113 may include, for example, a light-emitting diode or a xenon lamp. In an embodiment, one or more lenses (e.g., an infrared camera lens, a wide-angle lens, and a telephoto lens) and image sensors may be disposed on one surface of the electronic device 100. In an embodiment, the flash 113 may emit infrared rays, and the infrared light emitted by the flash 113 and reflected by a subject may be received through the third sensor module 119. The electronic device 100 or the processor (e.g., the processor 1020 in FIG. 1) of the electronic device 100 may detect depth information of the subject based on a time point when the infrared rays are received by the third sensor module 119.

The key input devices 117 may be disposed on the side surface 110C of the housing 110. In an embodiment, the electronic device 100 may not include some or all of the above-mentioned key input devices 117, and key input devices 117, which are not included, may be implemented in another form, such as soft keys, on the display 101. In an embodiment, the key input devices may include a sensor module disposed on the second surface 110B of the housing 110.

The light-emitting element 106 may be disposed on, for example, the first surface 110A of the housing 110. The light-emitting element 106 may provide, for example, the state information of the electronic device 100 in an optical form. In an embodiment, the light-emitting element 106 may provide a light source that is linked to the operation of, for example, a camera module (e.g., the first camera device 105). The light-emitting element 106 may include, for example, a light-emitting diode (LED), an infrared LED, and a xenon lamp.

The connector holes (e.g., a first connector hole 108 and a second connector hole 109) may include a first connector hole 108, which is capable of accommodating a connector (e.g., a USB connector) configured to transmit/receive power and/or data to/from an external electronic device (e.g., the electronic device 1002 in FIG. 1), and/or a second connector hole (e.g., an earphone jack) 109, which is capable of accommodating a connector for transmitting/receiving an audio signal to/from an external electronic device.

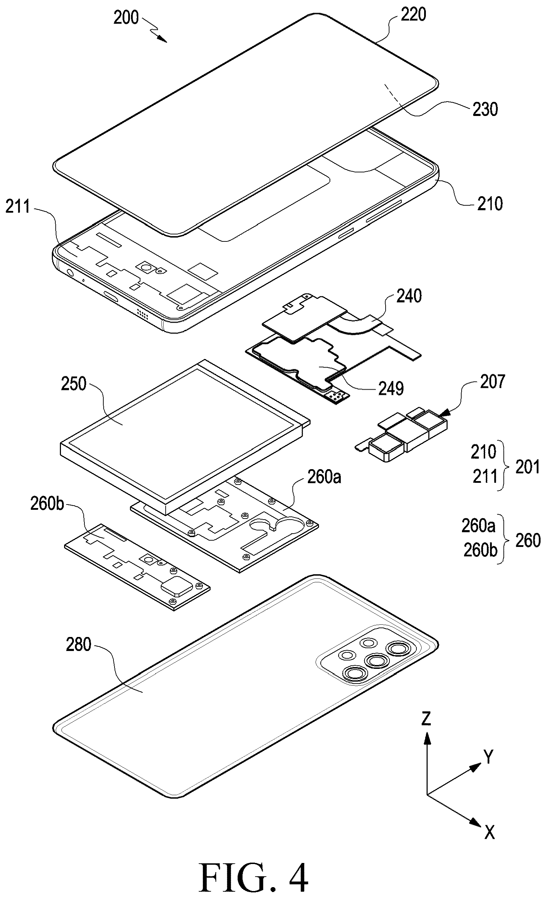

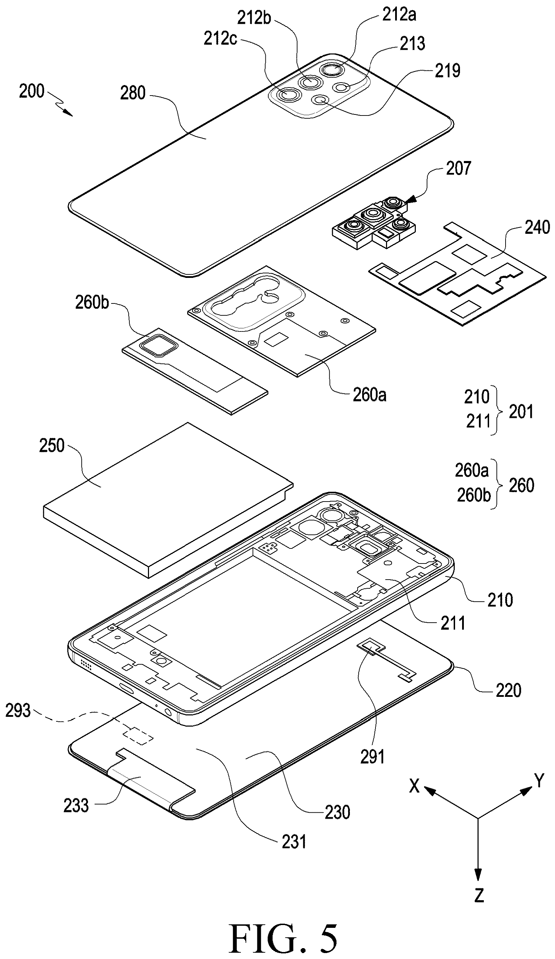

FIG. 4 is an exploded perspective view illustrating the front side of an electronic device 200 (e.g., the electronic device 100 illustrated in FIG. 2) according to an embodiment of the disclosure. FIG. 5 is an exploded perspective view illustrating the rear side of the electronic device 200 (e.g., the electronic device 100 illustrated in FIG. 2) according to an embodiment of the disclosure.

Referring to FIGS. 4 and 5, the electronic device 200 (e.g., the electronic device 1001, 1002, 1004, or 100 in FIG. 1, FIG. 2, or FIG. 3) may include a side surface structure 210, a first support member 211 (e.g., a bracket), a front surface plate 220 (e.g., the front surface plate 102 in FIG. 1), a display 230 (e.g., the display 101 in FIG. 1), a printed circuit board (or a substrate assembly) 240, a battery 250, a second support member 260 (e.g., a rear case), an antenna (not illustrated) (e.g., the antenna module 1097 in FIG. 1), a camera assembly 207, and a rear surface plate 280 (e.g., the rear surface plate 111 in FIG. 3). In an embodiment, in the electronic device 200, at least one of the components (e.g., the first support member 211 or the second support member 260) may be omitted, or other components may be additionally included. At least one of the components of the electronic device 200 may be the same as or similar to at least one of the components of the electronic device 100 of FIG. 2 or FIG. 3, and a redundant description thereof will be omitted below.

The first support member 211 may be arranged inside the electronic device 200 to be connected to the side surface structure 210 or may be integrated with the side surface structure 210. The first support member 211 may be made of, for example, a metal material and/or a non-metal (e.g., polymer) material. When at least partially being made of a metal material, a portion of the side surface structure 210 or the first support member 211 may serve as an antenna. The first support member 211 may include one surface to which the display 230 is coupled and the other surface to which the printed circuit board 240 is coupled. A processor (e.g., the processor 1020 in FIG. 1), memory (e.g., the memory 1030 in FIG. 1), and/or an interface (e.g., the interface 1077 in FIG. 1) may be mounted on the printed circuit board 240. The processor may include one or more of, for example, a central processing unit, an application processor, a graphics processing unit, an image signal processor, a sensor hub processor, or a communication processor. In an embodiment, the processor and/or the memory may refer to one of the circuit devices mounted on an integrated circuit chip.

According to an embodiment, the first support member 211 and the side surface structure 210 may be combined to be referred to as a front case or a housing 201. According to an embodiment, the housing 201 may be generally understood as a structure for accommodating, protecting, or disposing the printed circuit board 240 or the battery 250. In an embodiment, it may be understood that the housing 201 includes structures that a user may visually or tactfully recognize in the exterior of the electronic device 200, such as the side surface structure 210, the front surface plate 220, and/or the rear surface plate 280. In an embodiment, the 'front surface or rear surface of the housing 201' may refer to the first surface 110A in FIG. 2 or the second surface 110B in FIG. 3. In an embodiment, the first support member 211 may be disposed between the front surface plate 220 (e.g., the first surface 110A in FIG. 1) and the rear surface plate 280 (e.g., the second surface 110B in FIG. 3) and may serve as a structure on which electrical/electronic components, such as a printed circuit board 240 or a camera assembly 207, are arranged.

The display 230 may include a display panel 231 and a flexible printed circuit board 233 extending from the display panel 231. The flexible printed circuit board 233 may be understood, for example, to be electrically connected to the display panel 231 while being disposed at least partially on the rear surface of the display panel 231. In an embodiment, reference number '231' may be understood as denoting a protective sheet disposed on the rear surface of the display panel. For example, unless otherwise classified in the following detailed description, the protective sheet may be understood as being a part of the display panel 231. In an embodiment, the protective sheet may function as a buffer structure (e.g., a low-density elastic material such as a sponge) absorbing an external force or an electromagnetic shield structure (e.g., a copper sheet (CU sheet)). According to an embodiment, the display 230 may be disposed on the inner surface of the front surface plate 220 and may include a light-emitting layer to output a screen through at least a portion of the first surface 110A of FIG. 2 or the front surface plate 220. As mentioned above, the display 230 may output a screen through substantially the entire area of the first surface 110A of FIG. 2 or the front surface plate 220.

The memory may include, for example, volatile memory or non-volatile memory.

The interface may include, for example, a high-definition multimedia interface (HDMI), a universal serial bus (USB) interface, an SD card interface, and/or an audio interface. For example, the interface may electrically or physically connect the electronic device 200 to an external electronic device, and include a USB connector, an SD card/MMC connector, or an audio connector.

The second support member 260 may include, for example, an upper support member 260a and a lower support member 260b. In an embodiment, the upper support member 260a may be arranged to surround the printed circuit board 240 together with a portion of the first support member 211. For example, the printed circuit board 240 may be substantially positioned between the first support member 211 and the second support member 260 (e.g., the upper support member 260a). A circuit device implemented in the form of an integrated circuit chip (e.g., a processor, a communication module, or memory) or various electrical/electronic components may be disposed on the printed circuit board 240, and in some embodiments, the printed circuit board 240 may be provided with an electromagnetically shielded environment from the upper support member 260a. In an embodiment, at least one shield can 249 may be disposed on the printed circuit board 240. For example, the shield can 249 may provide an electromagnetic shielding environment to a portion or space on the printed circuit board 240. In an embodiment, the shield can 249 may be arranged to surround at least some of a processor, memory, and/or an integrated circuit chip having a communication module mounted thereon.

According to an embodiment, the lower support member 260b may be used as a structure on which electric/electronic components, such as a speaker module and an interface (e.g., a USB connector, an SD card/MMC connector, or an audio connector), are arranged. In an embodiment, electrical/electronic components, such as a speaker module and an interface (e.g., a USB connector, an SD card/MMC connector, or an audio connector), may be disposed on an additional printed circuit board (not illustrated). For example, the lower support member 260b may be arranged to surround the additional printed circuit board together with the other portion of the first support member 211. The speaker module or interface disposed on the additional printed circuit board (not illustrated) or the lower support member 260b may be arranged to correspond to the audio module of FIG. 2 (e.g., the microphone hole 103 or the speaker holes (e.g., the external speaker hole 107 and the call receiver hole 114)) or the connector holes (e.g., the first connector hole 108 and the second connector hole 109).

The battery 250 is a device for supplying power to at least one of the components of the electronic device 200 and may include, for example, a non-rechargeable primary battery, a rechargeable secondary battery, or a fuel cell. At least a portion of the battery 250 may be disposed on substantially the same plane as, for example, the printed circuit board 240. The battery 250 may be integrally arranged inside the electronic device 200, or may be arranged to be detachable from the electronic device 200.

Although not illustrated, the antenna may include a conductive pattern implemented on the surface of the first support member 211 and/or the surface of the second support member 260, for example, through laser direct structuring (LDS) techniques. In an embodiment, the antenna may include a printed circuit pattern provided on the surface of a thin film, and the thin film-type antenna may be disposed between the rear surface plate 280 and the battery 250. The antenna may include, for example, a near-field communication (NFC) antenna, a wireless charging antenna, and/or a magnetic secure transmission (MST) antenna. The antenna may, for example, perform short-distance communication with an external device, or wirelessly transmit and receive power required for charging. In an embodiment, an antenna structure may be configured with a portion or a combination of the side surface structure 210 and/or the first support member 211. In an embodiment, the electronic device 200 may include one or more antennas 291 and 293 arranged below the display 230. In an embodiment, the one or more antennas 291 and 293 may be understood as being built into the display 230. In an embodiment, the one or more antennas 291 and 293 may be located at a distance of about 1 mm or more from the display 230. In an embodiment, the one or more antennas 291 and 293 may be understood as being arranged substantially inside the electronic device 200, and located at a distance of about 10 mm or less, more specifically in some examples, about 5 mm or less, from the display 230. In an embodiment, when the electronic device 200 includes a plurality of antennas, the one or more antennas 291 and 293 may be located at a predetermined distance from an antenna that performs wireless communication in a similar frequency band. For example, when the one or more antennas 291 and 293 conduct wireless communication in a band of several tens of GHz, good communication quality may be secured by placing the one or more antennas 291 and 293 sufficiently far away from another antenna performing wireless communication in the band of several tens of GHz.

The camera assembly 207 may include at least one camera module. Inside the electronic device 200, the camera assembly 207 may receive at least some of light incident through optical holes or camera windows 212a, 212b, 212c, 213, and 219. In an embodiment, the camera assembly 207 may be disposed on the first support member 211 at a position adjacent to the printed circuit board 240. In an embodiment, one or more camera modules of the camera assembly 207 may be generally aligned with one of the camera windows 212a, 212b, 212c, 213, and 219, and may be at least partially surrounded by the second support member 260 (e.g., the upper support member 260a).

In discussing the embodiments described below, the above-described configurations of the electronic devices 1001, 1002, 1004, 100, and 200 may be referred to. Even if not directly mentioned, the configurations of the embodiments described above may be similarly applied to the embodiments described below. It should be noted that the orthogonal coordinate system referred to in an embodiment described above and/or described below is exemplified for the sake of brevity of explanation, and an embodiment(s) of the disclosure is(are) not limited thereto. For example, the orthogonal coordinate system mentioned in the disclosure may be defined differently depending on the shape of an electronic device to be actually manufactured (e.g., bar type, foldable type, rollable type, and/or slide type), a user's usage habits, and/or the orientation direction of the electronic device. In the exemplified embodiments, the X-axis direction may refer to the width direction of the electronic device, the Y-axis direction may refer to the length direction of the electronic device, and/or the Z-axis direction may refer to the thickness direction of the electronic device. In the embodiments described below, when an integrated circuit chip generates heat, the heat may move to a heat dissipation member through a contact-type heat-conducting material, and the direction of movement of the heat may be understood as being substantially parallel to the Z-axis direction. In the embodiments described below, the first direction may refer to one of the X-axis direction and the Y-axis direction, and the second direction may refer to the other of the X-axis direction and the Y-axis direction. For example, in discussing an embodiment(s) of the disclosure, it should be noted that the descriptions referring to 'direction', 'horizontal', and/or 'vertical' are for the sake of brevity of description, and the directions or relative positional relationships mentioned in the embodiments do not limit an embodiment(s) of the disclosure.

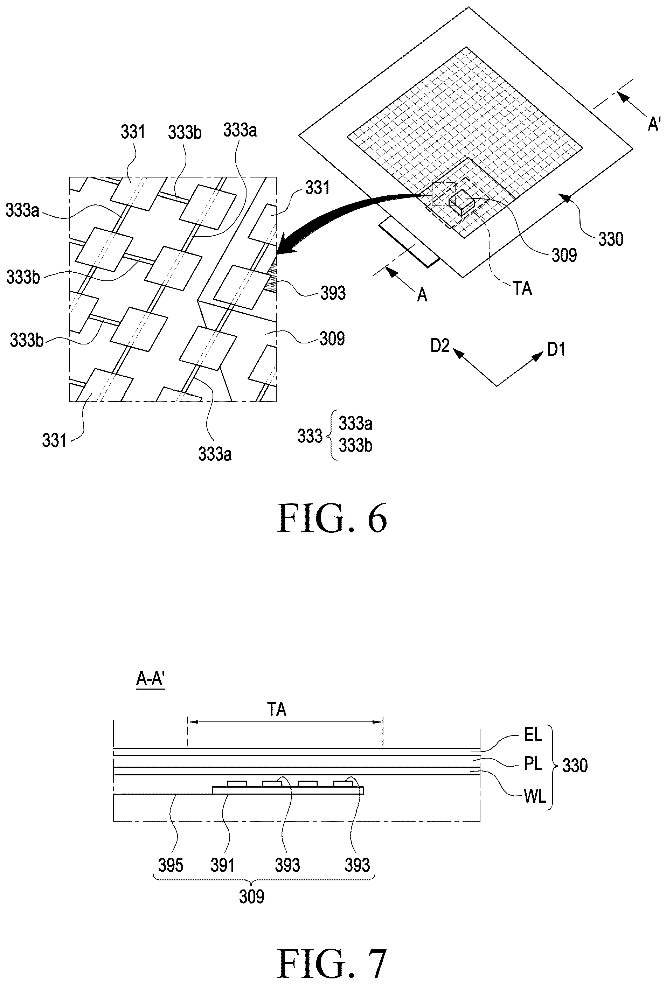

FIG. 6 is a view illustrating the arrangement of an antenna under a display of an electronic device according to an embodiment of the disclosure. FIG. 7 is a cross-sectional view illustrating the arrangement of an antenna in an electronic device according to an embodiment of the disclosure, in which a cross-sectional view of the display and/or the antenna taken along line A-A' of FIG. 6 is illustrated.

Referring to FIGS. 6 and 7, an electronic device (e.g., the electronic device 100 or 200 in FIGS. 2 to 5) may include an antenna 309 (e.g., the antenna 291 and 293 in FIG. 5) overlapping a display 330 (e.g., the display 230 in FIG. 5). Here, the description "an antenna overlaps a display" may refer to the antenna 309 being arranged either within or under the display 330. In describing an embodiment(s) of the disclosure, the description "the antenna is arranged either within or under the display" may refer to the antenna 309 being configured to transmit and receive wireless signals through a portion of the display 330. In an embodiment, the portion of the display 330 through which the wireless signals pass with respect to the antenna 309 may be defined as a transmissive area TA. In an embodiment, the portion of the display 330 through which wireless signals pass may be a portion of an active display area that outputs a screen. That is, the display 330 may comprise an active display area that displays a screen, and the portion of the display area through which wireless signals pass may be a portion of the active display area. For example, some of the pixels 331 of the display 330 may be arranged in the transmissive area TA. It may be understood that the antenna 309 according to an embodiment(s) of the disclosure substantially transmits and/or receives wireless signals through a portion of the active display area of the display 330.

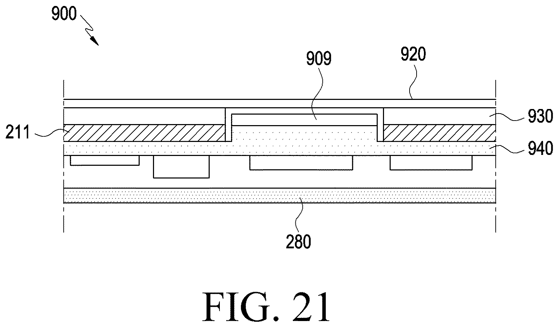

According to an embodiment, an electronic device (e.g., the electronic device 200 in FIG. 4 or FIG. 5) may include one or more antennas 309, arranged either to overlap the display 330 or under the display 330. In an embodiment, when the display 330 includes a buffer layer, a digitizer, a heat dissipation sheet, and/or an adhesive layer under the wiring layer WL, a portion of the buffer layer, the digitizer, the heat dissipation sheet, and/or the adhesive layer may be removed so that the one or more antennas 309 can be disposed under the display 330. In this case, a portion of the one or more antennas 309 may be described as being arranged at substantially the same height or on substantially the same plane as the display 330. In an embodiment, the one or more antennas 309 of FIG. 7 may be understood as being disposed under the wiring layer WL. It is noted that the one or more antennas are illustrated with the buffer layer, the digitizer, the heat dissipation sheet, and/or the adhesive layer of the display 330 omitted. In an embodiment, the one or more antennas 309 may be arranged partially at substantially the same height or on substantially the same plane as the wiring layer WL, the light-emitting layer PL, and/or the encapsulation layer EL of the display 330. For example, the one or more antenna 309 may be arranged in a space implemented by removing a portion of the wiring layer WL, the light-emitting layer PL, and/or the encapsulation layer EL on the display 330. The arrangement structure of the one or more antennas 309 will be reviewed again with reference to FIG. 21.

According to an embodiment, the antenna 309 may include at least one antenna radiator 393. For example, one or more antenna radiators 393 may be disposed under the display 330. When a plurality of antenna radiators 393 are arranged, the electronic device 200 may perform communication in a predetermined frequency band using a selected one of the antenna radiators 393, and individual antenna radiators 393 may conduct wireless communication in different frequency bands. In an embodiment, when including the plurality of antenna radiators 393, the electronic device 200 or the wireless communication circuit (e.g., the communication module 1090 or the wireless communication module 1092 in FIG. 1) may perform beam forming or beam steering through phase difference feeding. For example, the electronic device 200 or the communication module may adjust the direction where the antenna 309 is oriented by controlling the phase difference of communication signals provided to each of the antenna radiators 393.

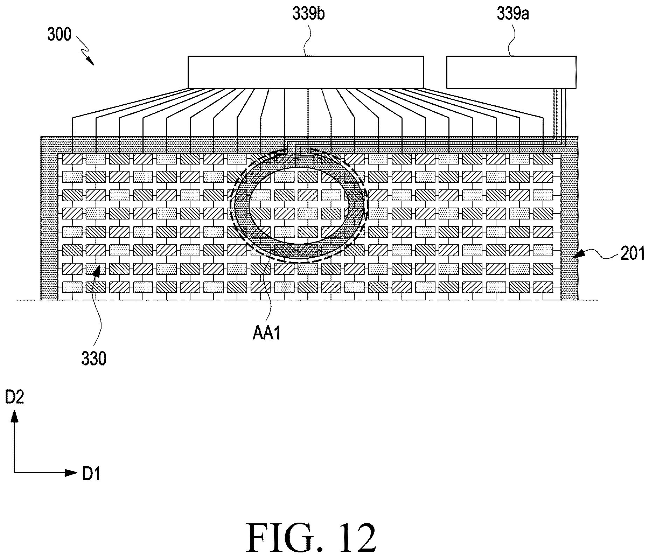

According to an embodiment, the display 330 may include a plurality of pixels 331 and control lines 333 that provide control signals to the pixels 331. The control lines 333 may be referred to as pixel control lines. The pixels 331 can each emit red, blue, and green light. For example, sub-pixels that emit red, blue, and green light, respectively, may be combined to implement one pixel 331. In an embodiment, at least some of the pixels 331 may further include sub-pixels that emit white light. In an embodiment, a processor (e.g., the processor 1020 in FIG. 1) may provide control signals to each of the pixels 331 via a control unit (e.g., the first control unit 339a and/or the second control unit 339b in FIG. 12) that controls or drives the display 330. In an embodiment, the control lines 333 may transmit such control signals to one or more corresponding pixels 331.

According to an embodiment, the control lines 333 may be implemented by transparent conductors that are not visible to the naked eye of a user, and may be arranged above or below the layer where the pixels 331 are arranged (e.g., a light-emitting layer PL). In an embodiment, the pixels 331 or the light-emitting layer PL may be arranged in a sealed or protected state by an encapsulation layer EL. In the illustrated embodiment, the light-emitting layer PL may be understood as being disposed between a layer on which the control lines 333 are arranged (e.g., a wiring layer WL) and the encapsulation layer EL. Although omitted in the drawing, an additional encapsulation layer may be provided under the light-emitting layer PL or under the wiring layer WL.

According to an embodiment, the display 330 comprises first pixel control lines 333a extending in a first direction D1 and second pixel control lines 333b extending in a second direction D2. For example, among the control lines 333, the first control lines 333a correspond to at least some of the pixels 331 and extend in a first direction D1, and among the control lines 333, the second control lines 333b correspond to at least some of the pixels 331 and extend along a second direction D2. The second direction D2 may be, for example, a direction intersecting the first direction D1, and in an embodiment, may be a direction perpendicular (or substantially perpendicular) to the first direction D1. As illustrated in FIG. 6, the first direction D1 and second direction D2 are directions in the plane of the display, i.e. parallel (or substantially parallel) to the display surface. The processor 1020 or the control unit may provide control signals to the pixels 331 via at least one of the first control lines 333a and the second control lines 333b. The control lines 333 and/or the pixels 331 may be understood as being substantially arranged in the active display area of the display 330. For example, the active display area of the display 330 is implemented by the arrangement of the pixels 331, and at least some of the control lines 333 may be arranged in the active display area of the display 330.

In some examples, the second control lines may be defined as control lines that extend only in the second direction (or a direction substantially similar to the second direction). In some examples, the second control lines may be defined as control lines that do not extend in the first direction (or do not extend in the first direction within the first active area). In some examples, the second control lines may be defined as control lines that do not extend in a direction substantially similar to the first direction (or do not extend in a direction substantially similar to the first direction within the first active area). In some examples, the second control lines may be defined as control lines that only extend in the first direction (or a direction substantially similar to the first direction) for a small proportion of their length. In some examples, the second control lines may be defined as control lines that only extend in the first direction within the first active area (or a direction substantially similar to the first direction) for a small proportion of their length within the first active area. For example, the second control lines may be defined as control lines that only extend in the first direction (or a direction substantially similar to the first direction) for less than 30% (or less than 25%, or less than 20%, or less than 15%, or less than 10%, or less than 5%, or less than 1%) of their length. For example, the second control lines may be defined as control lines that only extend in the first direction within the first active area (or a direction substantially similar to the first direction) for a for less than 30% (or less than 25%, or less than 20%, or less than 15%, or less than 10%, or less than 5%, or less than 1%) of their length within the first active area.

Similarly, in some examples, the first control lines may be defined as control lines that extend only in the first direction (or a direction substantially similar to the first direction). In some examples, the first control lines may be defined as control lines that do not extend in the second direction (or do not extend in the second direction within a third active area). In some examples, the first control lines may be defined as control lines that do not extend in a direction substantially similar to the second direction (or do not extend in a direction substantially similar to the second direction within the third active area). In some examples, the first control lines may be defined as control lines that only extend in the second direction (or a direction substantially similar to the second direction) for a small proportion of their length. In some examples, the first control lines may be defined as control lines that only extend in the second direction within the third active area (or a direction substantially similar to the second direction) for a small proportion of their length within the third active area. For example, the first control lines may be defined as control lines that only extend in the second direction (or a direction substantially similar to the second direction) for less than 30% (or less than 25%, or less than 20%, or less than 15%, or less than 10%, or less than 5%, or less than 1%) of their length. For example, the first control lines may be defined as control lines that only extend in the second direction within the third active area (or a direction substantially similar to the second direction) for a for less than 30% (or less than 25%, or less than 20%, or less than 15%, or less than 10%, or less than 5%, or less than 1%) of their length within the second active area.

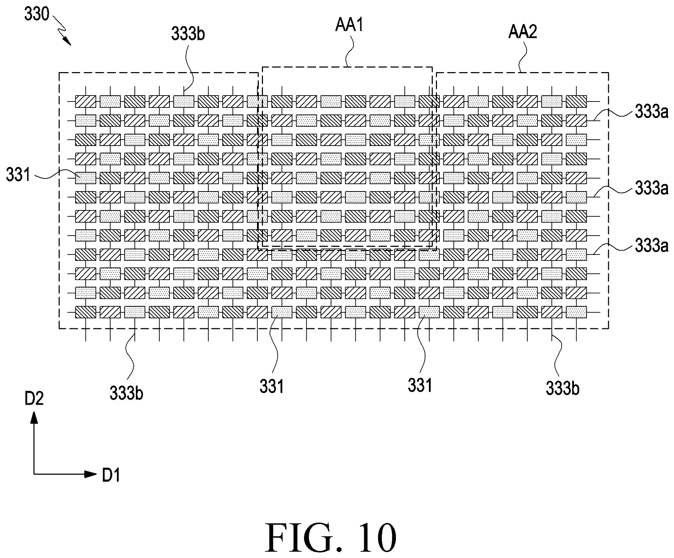

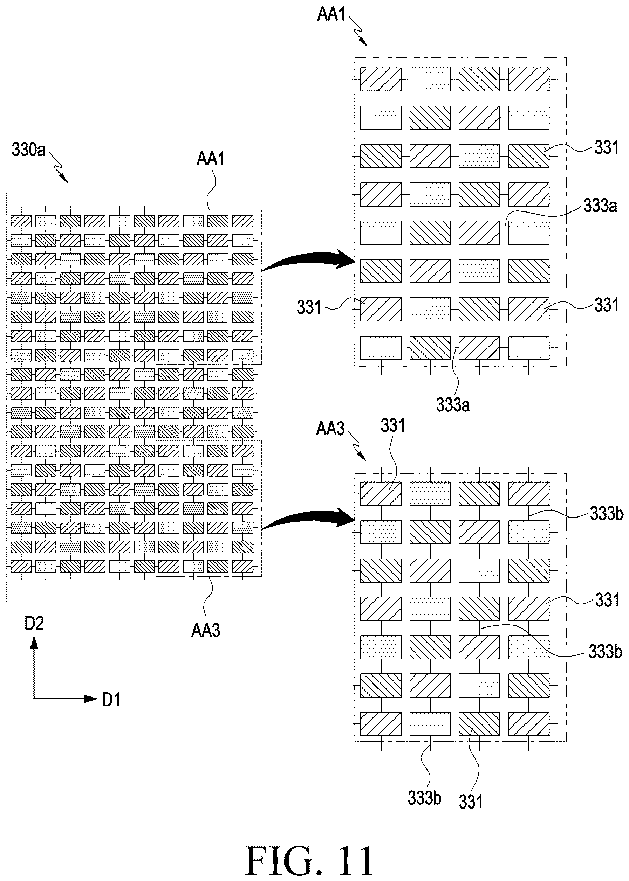

According to an embodiment, in the active display area of the display 330, the arrangement of the pixels 331 and/or the arrangement of the control lines 333 may substantially implement a grid shape or a mesh shape. For example, when the pixels 331 are arranged more densely, the display 330 may output a higher quality image. In an embodiment, in a portion of the active display area of the display 330, some of the first control lines 333a may be arranged, but the second control lines 333b may not be arranged. For example, the display 330 may include a first active area (e.g., the first active area AA1 in FIG. 10 or FIG. 11) comprising a first set of pixels, wherein at least one first pixel control line 333a is arranged in the first active area but none of the second control lines 333b are arranged in the active area. In an embodiment, the entire active display area of the display 330 may be provided as the area where the first control lines 333a are arranged, but the second control lines 333b are not arranged. The area within the active display area of the display 330 where some of the first control lines 333a are arranged, but the second control lines 333b are not arranged may be defined as a transmissive area TA (e.g., the first active area AA1 in FIG. 10 or FIG. 11) when viewed by the antenna 309. For example, the antenna 309 may be disposed under the display 330 to at least partially overlap the transmission TA. When the specifications or space of the electronic device 200 allow, a plurality of transmissive areas TA may be provided for one display 330.

According to an embodiment, when arranged to overlap the area where some of the first control lines 333a are arranged and the second control lines 333b are not arranged (e.g., the transmissive area TA), the antenna 309 may be configured to radiate a wireless signal with a first polarization component corresponding to a specific direction, and may be configured not to radiate a wireless signal with a different polarization component. For example, when the first direction D1 is defined as a horizontal direction, the antenna 309 may conduct wireless communication using vertically polarized waves. In an embodiment, when the first direction D1 is defined as a vertical direction, the antenna 309 may be understood as radiating horizontally polarized waves. That is, since the transmissive area TA does not include (or substantially does not include) control lines extending in a particular direction, the wireless communication may be conducted through the transmissive area TA using waves polarized in that particular direction. For example, the wireless communication may be conducted through the first active area AA1 using waves polarized in the second direction D2, since second control lines 333b extending in the second direction D2 are not arranged in the first active area AA1.

According to an embodiment, the area in which some of the first control lines 333a are arranged, but the second control lines 333b are not arranged in the active display area of the display 330 may be defined as a first active area AA1. As will be described in more detail with reference to FIG. 10 or FIG. 11, the display 330 may include a second active area AA2 as another portion of the active display area. The second active area AA2 may comprise a second set of pixels. In some examples, at least one of the first pixel control lines 333a is arranged in the second active area AA2 and at least one of the second pixel control lines 333b is arranged in the second active area AA2. For example, the second active area AA2 may refer to an area in which a grid shape is implemented by, for example, arranging some of the other first control lines and at least some of the second control lines together. In an embodiment, the first control lines 333a arranged in the first active area AA1 may also be partially arranged in the second active area AA2.

According to an embodiment, a third active area (e.g., the third active area AA3 in FIG. 11) may be defined as another portion of the active display area of the display 330 in which some of the second control lines 333b are arranged, but the first control lines 333a are not arranged. The third active area AA3 may comprise a third set of pixels. In some examples, at least one of the second pixel control lines 333b is arranged in the at least one third active area AA3 but none of the first pixel control lines 333a are arranged in the at least one third active area AA3. When the antenna 309 arranged to overlap the first active area AA1 is configured to radiate first polarized waves, another antenna configured to radiate second polarized waves rather than the first polarization may be arranged to overlap the third active area AA3. For example, the second polarized waves may be waves polarized in the first direction.

According to an embodiment, when the antenna 309 performs wireless communication, the control lines 333 may act as obstacles that distort or block the wireless signals. In an embodiment, when the control lines 333 are arranged in a grid shape and/or when the spacing between the control lines 333 is as small as tens of micrometers or less, it may be practically impossible to conduct wireless communication through the display 330 and/or the wiring layer WL. In an embodiment(s) of the disclosure, an antenna may be disposed under the display to overlap a transmissive area or the first active area, and may transmit and receive wireless signals with a polarization component that penetrates the transmissive area or the first active area. Under the display, the antenna may be arranged to overlap the transmissive area or the first active area, and may not substantially overlap the second active area.

According to an embodiment, the pixels 331 implementing the active display area of the display 330 may have a horizontal length or a vertical length of about 200 µm, and may be arranged at intervals of about 60 µm or more and about 160 µm or less. For example, the interval between the pixels 331 may be about 157 µm, and the interval may be adjusted to a minimum of about 60 µm. In the arrangement structure of these pixels 331, when the antenna 309 is arranged to overlap the first active area AA1 to conduct wireless communication through the first active area AA1, the spacing between the display 330 and the antenna 309 may vary depending on the communication frequency. In an embodiment, when pixels 331 of about 200 µm in size are arranged at intervals of about 157 µm, it was identified that the antenna 309 conducting wireless communication using the frequency of about 13 GHz band is capable of conducting stable wireless communication when arranged at a distance of about 1 mm or more from the display 330. In an embodiment, when pixels 331 of about 200 µm in size are arranged at intervals of about 157 µm, the antenna 309 conducting wireless communication using the frequency of about 13 GHz band may be arranged at a distance of about 7 mm or less from the display 330.

In the illustrated embodiment, it is exemplified that one antenna 309 and one transmissive area TA (or first active area AA1) are arranged in one display 330, but it should be noted that an embodiment(s) of the disclosure is(are) not limited thereto. For example, a plurality of antennas 339 and the corresponding number of transmissive areas TA (or first active areas AA1) may be provided in one display 330, and depending on the structure of the electronic device 200, one antenna 309 may be arranged in one display 330, but a plurality of transmissive areas TA (or first active areas AA1) may be provided.

According to an embodiment, the antenna 309 may include a substrate 391, one or more antenna radiators 393, and/or a connecting wire 395. In one embodiment, the one or more antenna radiators 393 may be implemented in the form of a printed circuit pattern on the substrate 391. For example, the one or more antenna radiators 393 may be understood as being substantially a part of the substrate 391. In an embodiment, the substrate 391 may be understood as being a part of the antenna radiator 393. Depending on the frequency band for conducting wireless communication using the antenna 309, the shape, size, number, and/or arrangement of antenna radiators 393 may vary. In an embodiment, a plurality of antenna radiators 393 may be arranged to overlap one transmissive area TA (or one first active area AA1). The antenna radiators 393 arranged to overlap one transmissive area TA (or one first active area AA1) may conduct wireless communication using signals having the same polarization component. In an embodiment, when conducting wireless communication using millimeter waves, the antenna 309 may include antenna radiators 393 arranged in a 1 by 2 array, antenna radiators 393 arranged in a 1 by 4 array, antenna radiators 393 arranged in a 2 by 2 array, or antenna radiators 393 arranged in a 2 by 4 array. However, an embodiment(s) of the disclosure is(are) not limited thereto, and when the inner space of the electronic device 200 allows, the antenna 309 may include a greater number of antenna radiators 393.

According to an embodiment, the antenna 309 may be electrically or operatively connected to a wireless communication circuit (e.g., the wireless communication module 1092 or the communication module 1090 in FIG. 1). For example, the antenna 309 (e.g., the one or more antenna radiators 393) may receive signals from the wireless communication circuit and conduct wireless communication. In an embodiment, the antenna 309 (e.g., the one or more antenna radiators 393) may be configured to substantially radiate signals, received from the wireless communication circuit, in a predetermined polarization, rather than in a polarization other than the predetermined polarization. For example, when configured to radiate vertically polarized waves, the antenna 309 may not substantially radiate horizontally polarized waves.

In an embodiment, the connecting wire 395 may extend from the substrate 391 and may be electrically connected to a main circuit board (e.g., the printed circuit board (or board assembly) 240 in FIG. 5). In an embodiment, the connecting wire 395 may be understood as being substantially a part of the substrate 391. For example, although the connecting wire 395 is described as being separate from the substrate 391, an embodiment(s) of the disclosure is(are) not limited thereto, and the connecting wire 395 and the substrate 391 may substantially refer to different portions of a single-pieced substrate. In an embodiment, the connecting wire 395 may refer to a portion of the single-pieced substrate that is more flexible than the area where the one or more antenna radiators 393 are arranged. In an embodiment, the connecting wire 395 may be implemented by a flexible printed circuit board.

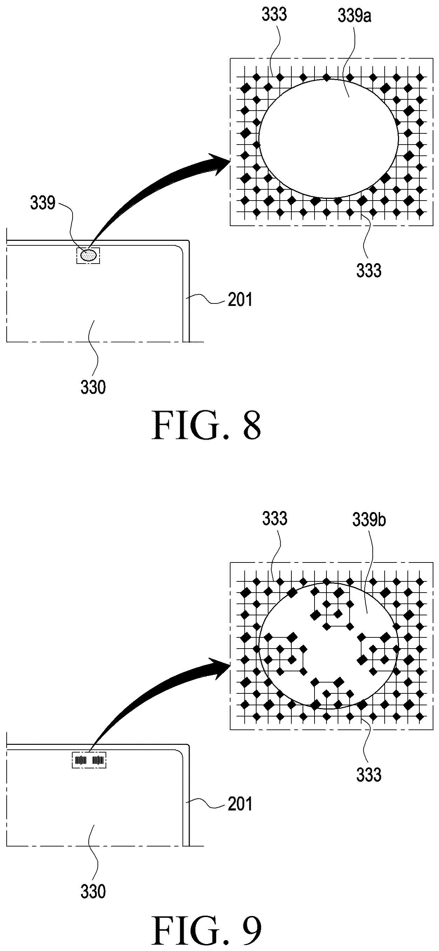

FIG. 8 is a view illustrating a display of an electronic device according to an embodiment of the disclosure. FIG. 9 is a view illustrating a display of an electronic device according to an embodiment of the disclosure.

Referring to FIGS. 8 and 9, the display 330 may include an area in which the distribution density of pixels (e.g., the pixels 331 in FIG. 6) is lower than that of other areas. Hereinafter, the area in which the distribution density of pixels 331 of the active display area of the display 330 is lower than that of other areas may be referred to as a dummy area 339a or 339b. In an embodiment, the dummy areas 339a and 339b may allow for easier permeation of light or radio waves than the remaining area of the display 330. For example, the dummy areas 339a and 339b may function as transmissive areas (or first active areas) (e.g., the transmissive area TA in FIG. 6 or FIG. 7) that provides a stable operating environment to a camera or an antenna (e.g., the antenna 309 in FIG. 6 or FIG. 7).

According to an embodiment, in a first dummy area 339a of FIG. 8, pixels 331 may be substantially not arranged. In the first dummy area 339a where pixels 331 are not arranged, control lines (e.g., the control lines 333 in FIG. 6) may not be arranged. For example, when arranged to overlap the first dummy area 339a, the camera or antenna 309 may perform a photographing or wireless communication function without interference with the display 330. In an embodiment, the first dummy area 339a is substantially a part of the active display area of the display 330 where pixels 331 are removed, which may deteriorate the emotional quality in terms of the picture quality or the appearance of the electronic device 200.

According to an embodiment, pixels 331 may be arranged in the second dummy area 339b of FIG. 9, but the distribution density of the pixels 331 may be lower than that of the remaining area of the display 330. Since the distribution density of pixels 331 is lower than the remaining area of the display 330, the distribution density of control lines 333 in the second dummy area 339b may be lower than the remaining area of the display 330. For example, the second dummy area 339b may provide improved picture quality or improved appearance quality compared to the first dummy area 339a where pixels 331 are substantially removed. In an embodiment, the distribution density of pixels 331 in the second dummy area 339b may be adjusted to a degree that does not affect a photographing or wireless communication function. For example, when implementing the second dummy area 339b, pixels 331 and/or control lines 333 may be arranged at a distribution density that allows photographing or wireless communication. In an embodiment, the second dummy area 339b may provide a photographing or wireless communication environment that is lower than that of the first dummy area 339a, while providing improved image quality or improved appearance quality than that of the first dummy area 339a.

FIG. 10 is a view to be referred to describe the arrangement of control lines in a display of an electronic device according to an embodiment of the disclosure. FIG. 11 is a view to be referred to describe the arrangement of control lines in a display of an electronic device according to an embodiment of the disclosure.

First, referring to FIG. 10, a display 330 may include first control lines 333a extending in a first direction D1 and second control lines 333b extending in a second direction D2. Here, the 'second direction D2' may be a direction intersecting the first direction D1. In an embodiment, the second direction D2 may be understood as being substantially perpendicular to the first direction D1. In an embodiment, the first control lines 333a may extend along the first direction D1 but may be arranged along the second direction D2, and the second control lines 333b may extend along the second direction D2 but may be arranged along the first direction D1.

According to an embodiment, in a portion of the active display area of the display 330, for example, a first active area AA1 (e.g., the transmissive area TA in FIG. 6 or FIG. 7), some of the first control lines 333a are arranged, and no second control lines 333b are arranged. In some example, one second control line 333b is arranged in an edge region of the first active area AA1, thereby defining a boundary of the first active area AA1. In an embodiment, the second active area AA2 may refer to an area where the first control lines 333a and the second control lines 333b are arranged together. For example, among the plurality of pixels 331, at least some of the pixels 331 (e.g. the first set of pixels) arranged in the first active area AA1 may receive control signals through some of the first control lines 333a rather than the second control lines 333b, and at least some of the other pixels 331 (e.g. the second set of pixels) may receive control signals through the first control lines 333a and the second control lines 333b while being arranged in the second active area AA2. In an embodiment, in another portion of the active display area of the display 330, for example, the third active area AA3 in FIG. 11, the first control lines 333a may not be substantially arranged, but some of the second control lines 333b may be arranged. Here, "the first control line 333a is not substantially arranged" can be understood that the third active area AA3 provides an environment in which wireless communication can be performed using a designated polarization even if the third active area AA3 includes the first control line 333a. In an embodiment, the pixels 331 in the third active area AA3 may receive control signals through the second control lines 333b rather than the first control lines 333a.

In an embodiment, the electronic device 200 or the display 330 may include a plurality of first active areas AA1. For example, the electronic device 200 may include a plurality of antennas (or a plurality of antenna radiators) (e.g., the antennas 309 in FIG. 6 or FIG. 7), and the plurality of antennas 309 may be disposed under the display 330 to overlap a corresponding one of the plurality of first active areas AA1. In an embodiment, the electronic device 200 may include a plurality of antennas 309 (or a plurality of antenna radiators) arranged to overlap a single first active area AA1. When the first control lines 333a are defined as extending in a horizontal direction, it may be understood that the antennas 309 arranged to overlap the first active area AA1 conducts wireless communication using vertically polarized waves. In an embodiment, the first control lines 333a may be defined as extending in the vertical direction. In this case, the antennas 309 arranged to overlap the first active area AA1 may be understood as conducting wireless communication using horizontally polarized waves. When a plurality of first active areas AA1 and/or a plurality of antennas 309 corresponding thereto are provided, the plurality of antennas 309 may be understood as conducting wireless communication using substantially the same polarization component.

According to an embodiment, the electronic device 200 or display 330 may include one or more first active areas AA1 and one or more third active areas AA3. In this case, the first antenna (or the first antenna radiator) (e.g., the antenna 309 in FIG. 6 or FIG. 7) may be arranged to correspond to (or overlap) the one or more first active areas AA1, and a second antenna (or a second antenna radiator) may be arranged to correspond to (or overlap) the one or more third active areas AA3. In an embodiment, the first antenna and the second antenna may be understood as conducting wireless communication using different polarization components. When the second control lines 333b are defined as extending in the vertical direction, the second antennas arranged to overlap the third active area AA3 can be understood as conducting wireless communication using horizontally polarized waves. For example, when the one or more first active areas AA1 and the one or more third active areas AA3 are provided and a plurality of antennas 309 corresponding thereto are provided, it may be understood that some of the plurality of antennas 309 conduct wireless communication using polarization components different from some of the other antennas 309. In an embodiment, the one or more first active areas AA1 and the one or more third active areas AA3 may be arranged at a position where a stable wireless communication environment can be ensured on the electronic device 200. For example, considering that other electronic components or other antennas are disposed on the electronic device 200, the positions of the one or more first active areas AA1 and the one or more third active areas AA3 and/or the positions of the one or more antennas 309 corresponding to the one or more first active areas AA1 and the one or more third active areas AA3 may be selected.

FIG. 12 is a view to be referred when describing an electronic device according to an embodiment of the disclosure.

Referring to FIG. 12, a first active area AA1 may have a circular, elliptical, or polygonal shape on a display 330. In an embodiment, although not illustrated, a portion of the first active area AA1 (e.g., an area illustrated in shade) may be implemented as an area where pixels 331 are not arranged. As described with reference to FIG. 8, although not illustrated in FIG. 12, the first active area AA1 may be implemented as an area in which pixels 331 are not substantially arranged. When pixels 331 are not arranged, the first control lines 333a and/or the second control lines 333b may not be substantially arranged in the first active area AA1. For example, when the pixels 331, the first control lines 333a, and/or the second control lines 333b are not arranged in at least a portion of the first active area AA1, an antenna (e.g., the antenna 309 in FIG. 6 or FIG. 7) arranged to overlap the first active area AA1 may be provided with a more stable wireless communication environment.

According to an embodiment, in the arrangement of the control lines, when the first active area AA1 (e.g., the first active area AA1 in FIG. 10 or FIG. 11) is implemented differently from the remaining portion (e.g., the second active area AA2 in FIG. 10) of the active display area of the display 330, the electronic device 300 may include a plurality of control units 339a and 339b configured to drive the pixels 331. For example, the electronic device 300 may include a first control unit 339a configured to control the operation of the pixels 331 of the first active area AA1, and/or a second control unit 339b configured to control the operation of the pixels 331 of the second active area AA2 (e.g., the second active area AA2 in FIG. 10). Although not illustrated, when the display 330 further includes a third active area AA3 (e.g., the third active area AA3 in FIG. 11), the electronic device may further include a third control unit to control the operation of the pixels 331 of the third active area AA3. However, the embodiment(s) of the disclosure are not limited thereto, and the electronic device 300 may include any one of the first control unit 339a, the second control unit 339b, and/or the third control unit, and substantially the entire active display area of the display 330 may be controlled by one control unit.

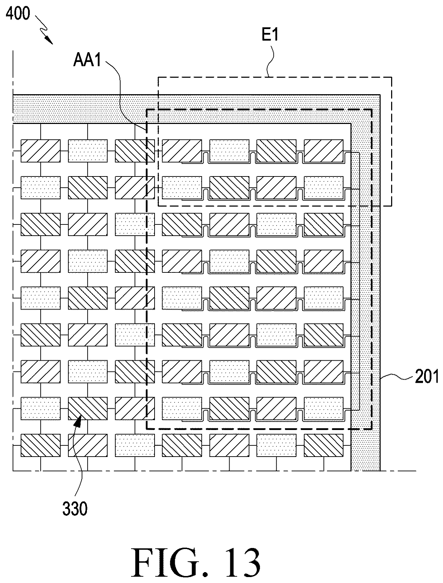

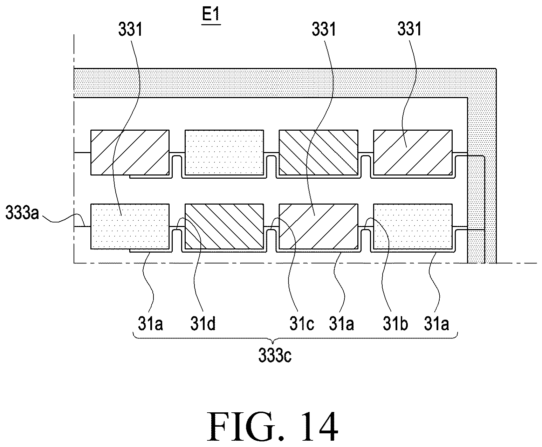

FIG. 13 is a view to be referred to describe an electronic device according to an embodiment of the disclosure. FIG. 14 is a view to be referred to describe an electronic device according to an embodiment of the disclosure, illustrating an enlarged view of the portion 'E1' in FIG. 13.

Referring to FIGS. 13 and 14, in the area where the first control lines 333a are provided and the second control lines 333b are not provided, for example, in the first active area AA1, the electronic device 400 and/or the display 330 may further include third control lines 333c substantially extending along the first direction D1. The third control lines 333c may be arranged to correspond to the pixels 331 arranged in the first active area AA1, for example, and transmit control signals from a control unit (e.g., the first control unit 339a or the second control unit 339b in FIG. 12) to the pixels 331 of the first active area AA1. In an embodiment, at least some of the control signals may be provided to the pixels 331 of the first active area AA1 via a combination of the first control lines 333a and the third control lines 333c. Although not illustrated, in the area where the second control lines 333b are provided and the first control lines 333a are not provided, for example, in the third active area AA3 of FIG. 11, the electronic device 400 and/or the display 330 may further include fourth control lines extending substantially along the second direction D2. The fourth control lines may differ in extension direction or arrangement and may be substantially identical to one or more third control lines 333c.

According to an embodiment, the one or more third control lines 333c (or one or more fourth control lines) may include, for example, one or more portions (e.g., first portions 31a) substantially arranged to surround at least one side of at least one of the pixels 331 of the first active area AA1. The one or more first portions 31a may be configured to provide, for example, data or control signals to the corresponding pixels 331. For example, the one or more third control lines 333c may be configured to provide data or control signals from the above-described control units (e.g., the first control unit 339a or the second control unit 339b in FIG. 12) to at least one of the corresponding pixels 331. In an embodiment, the data or control signals may be directly transmitted to the corresponding pixels 331 through the first portions 31a of the one or more third control lines 333c.

According to an embodiment, the one or more third control lines 333c (or fourth control lines) may include one or more second portions 31b, one or more third portions 31c or one or more fourth portions 31d that protrude in a direction (e.g., the second direction D2) intersecting the first direction D1 between two adjacent pixels 331. The one or more second portions 31b, third portions 31c, or fourth portions 31d may be connected to each other through one of the first portions 31a, and the two adjacent first portions 31a may be connected to each other via one of the one or more second portions 31b, the third portions 31c, or fourth portions 31d. For example, the one or more third control lines 333c (or fourth control lines) may generally extend in the first direction D1 (or the second direction D2) and may have a shape partially protruding from the first portions 31a or a zigzag shape. In an embodiment, it may be understood that the one or more third control lines 333c are implemented by arranging the first portions 31a and the second portions 31b alternately along the first direction D1 (or the second direction D2).

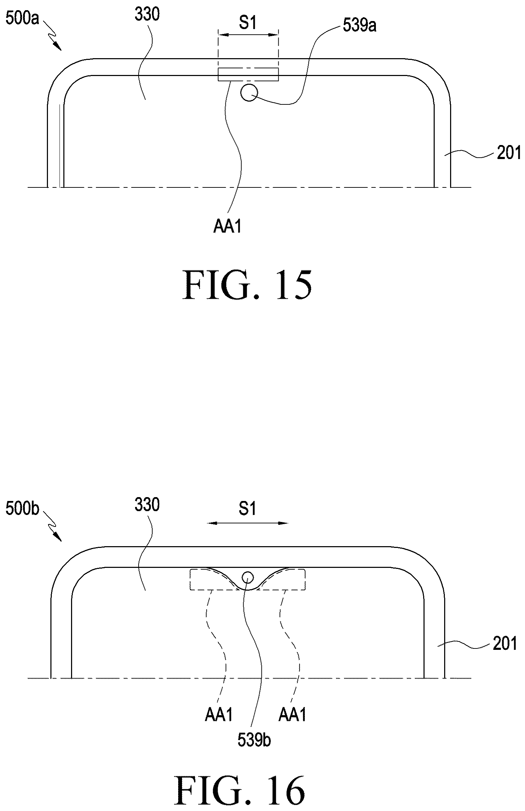

FIG. 15 is a view illustrating an electronic device according to an embodiment of the disclosure. FIG. 16 is a view illustrating an electronic device according to an embodiment of the disclosure.

Referring to FIGS. 15 and 16, a display 330 may include an optical hole 539a substantially surrounded by an active display area, or a notch area 539b extending from an edge to the inside of the active display area of the display 330. In an embodiment, the optical hole 539a or the notch area 539b may be arranged adjacent to or substantially in contact with a portion of an edge of the display 330 (e.g., a first section S1). When the display 330 includes the above-described first active area AA1 or third active area AA3, the first active area AA1 or the third active area AA3 may be arranged adjacent to the first section S1. For example, the first active area AA1 or the third active area AA3 may be implemented between the first section S1 and the optical hole 539a, or may be disposed to be in contact with a curved portion of the edge of the notch area 539b. As mentioned above, an electronic device 500a or 500b may include one or more antennas (e.g., the antennas 309 in FIG. 6 or FIG. 7) disposed under the display 330 to overlap the first active area AA1 or the third active area AA3.

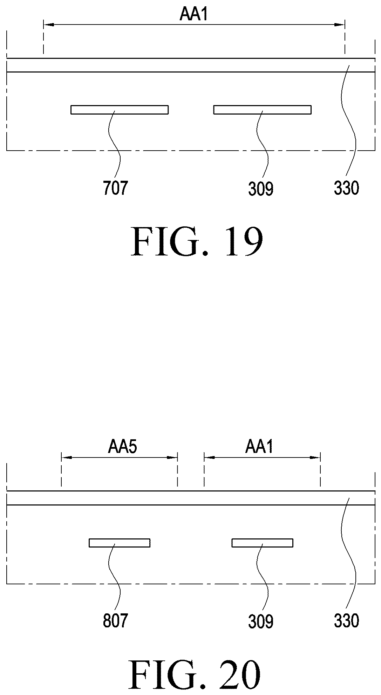

According to an embodiment, the electronic device 500a or 500b may include a sensor arranged to correspond to the optical hole 539a or the notch area 539b. The sensor may include, for example, a camera, a proximity sensor, a light sensor, a fingerprint recognition sensor, a facial recognition sensor, and/or an iris recognition sensor. For example, when the electronic device 500a or 500b includes an antenna that overlaps the display 330, the antenna may be adjacent to but not overlap the sensor, and may transmit and receive wireless signals through the first active area AA1 or the third active area AA3. The arrangement of such antennas and/or sensors will be discussed again with reference to FIGS. 19 and 20.

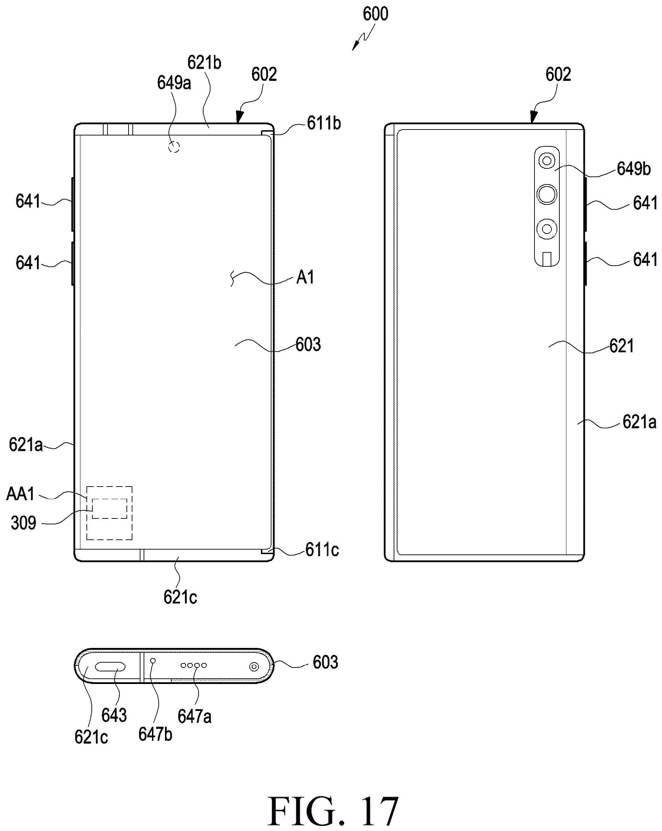

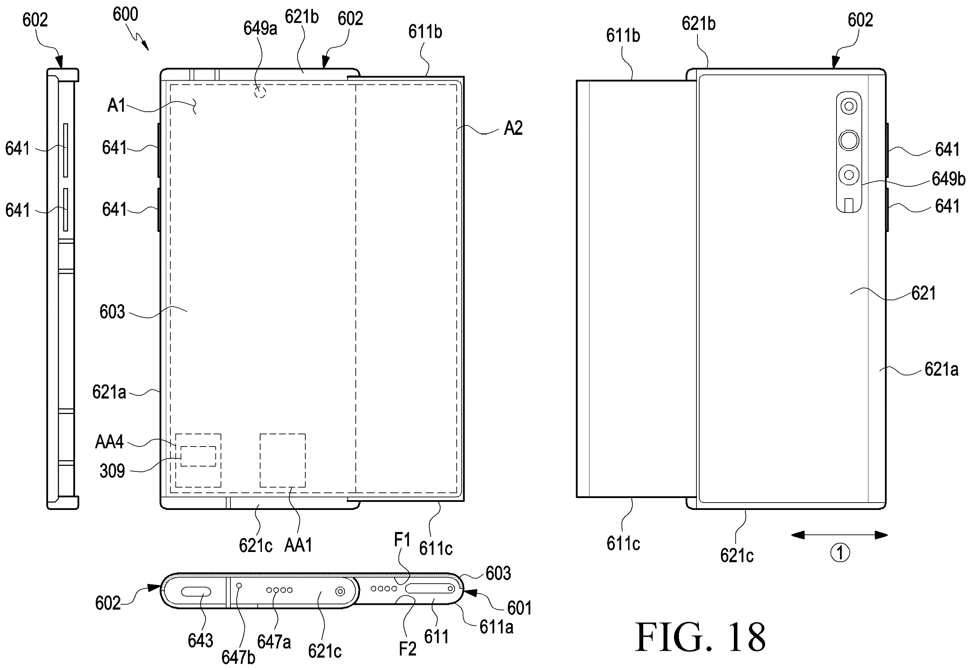

FIG. 17 is a view illustrating the state in which a second display area of a display according to an embodiment of the disclosure is accommodated in a second housing. FIG. 18 is a view illustrating the state in which the second display area of the display according to an embodiment of the disclosure is exposed to the outside of the second housing.

FIGS. 17 and 18 illustrate a structure in which a display 603 (e.g., a flexible display) gradually expands as the first housing 601 moves rightward with respect to the second housing 602 when viewed from the front of the electronic device 600. However, the relative movement direction of the housings 601 and 602 or the expansion direction of the display 603 is not limited to one direction (e.g., rightward). The display may be designed to expand leftward and/or bidirectionally. In some embodiments, the display may be designed to expand upward and/or downward. The expansion direction of the display mentioned herein is an example based on the alignment direction illustrated in the drawings for the sake of simplicity of description, and the direction in which the display expands may be described in various ways depending on the structure of the actually manufactured electronic device or the arrangement direction of the electronic device according to a user's usage habits.

The state illustrated in FIG. 17 may be defined as the state in which the first housing 601 is closed relative to the second housing 602, and the state illustrated in FIG. 18 may be defined as the state in which the first housing 601 is opened relative to the second housing 602. According to an embodiment, the "closed state" or the "opened state" may be defined as the state in which the electronic device is closed or the state in which the electronic device is opened.

Referring to FIGS. 17 and 18, the electronic device 600 may include housings 601 and 602. The housings 601 and 602 may include a second housing 602 and a first housing 601 arranged to be movable relative to the second housing 602. In some embodiments, the electronic device 600 may be interpreted as having a structure in which the second housing 602 is arranged to be slidable on the first housing 601. According to an embodiment, the first housing 601 may be arranged to be reciprocable by a predetermined distance in the illustrated direction (e.g., the direction indicated by arrow ①) with respect to the second housing 602.

According to an embodiment, the electronic device 600 may comprise the first housing 601; and the second housing 602 configured to be moveable relative to the first housing 601 between a first position and a second position to change the size of the exposed active display area of the display 603, wherein the antenna radiator 309 may be arranged in the second housing 602. At least one first active area AA1 may be disposed on the display 603 to at least partially overlap with the antenna radiator 309 when the second housing 602 is in the first position such that the antenna radiator 309 can transmit wireless signals with a polarization component passing through the at least one first active area AA1 when the second housing 602 is in the first position. The display may further comprise at least one fourth active area AA4 which is another portion of the active display area of the display 603 and may comprise a fourth set of pixels. At least one of the first pixel control lines 333a may arranged in the at least one fourth active area but none of the second pixel control lines may be arranged in the at least one fourth active area AA4. The at least one fourth active area AA4 may be disposed on the display 603 to at least partially overlap with the antenna radiator 309 when the second housing 602 is in the second position such that the antenna radiator 309 transmits wireless signals with a polarization component passing through the at least one fourth active area AA4 when the second housing 602 is in the second position.

According to an embodiment, the first housing 601 may be referred to as, for example, a first structure, a slide unit, or a slide housing, and may be arranged to be reciprocable on the second housing 602. According to an embodiment, the first housing 601 may accommodate various electrical and electronic components such as a circuit board or a battery. The second housing 602 may be referred to as, for example, a second structure, a main unit, or a main housing, and may guide the movement of the first housing 600. A portion of the display 603 (e.g., the first display area A1) may be seated on the first housing 601 or the second housing 602. In an embodiment, as the first housing 601 moves (e.g., slides) relative to the second housing 602, another portion of the display 603 (e.g., the second display area A2) may be accommodated into the interior of the first housing 601 and/or the second housing 602 (e.g., the slide-in operation) or may be exposed to the exterior of the first housing 601 and/or the second housing 602) (e.g., the slide-out operation). According to an embodiment, a motor, a speaker, a SIM socket, and/or a sub-circuit board electrically connected to a main circuit board may be arranged in the first housing 601. The main circuit board on which electrical components such as an application processor (AP) and a communication processor (CP) are mounted may be arranged within the second housing 602.

According to an embodiment, the first housing 601 may include a first plate 611 (e.g., a slide plate). The first plate 611 may include a first surface (e.g., the first surface F1 in FIG. 18) forming at least a portion thereof and a second surface F2 facing away from the first surface F1. According to an embodiment, the first plate 611 may support at least a portion of the display 603 (e.g., the first display area A1). According to an embodiment, the first housing 601 may include a first plate 611, a (1-1)^{th} side wall 611a extending from the first plate 611, a (1-2)^{th} side wall 611b extending from the (1-1)^{th} side wall 611a and the first plate 611, and a (1-3)^{th} side wall 611c extending from the (1-1)^{th} side wall 611a and the first plate 611 and substantially parallel to the (1-2)^{th} side wall 611b.

According to an embodiment, the second housing 602 may include a second plate 621 (e.g., a main case), a (2-1)^{th} side wall 621a extending from the second plate 621, a (2-2)^{th} side wall 621b extending from the (2-1)^{th} side wall 621a and the second plate 621, and a (2-3)^{th} side wall 621c extending from the (2-1)^{th} side wall 621a and the second plate 621 and substantially parallel to the (2-2)^{th} side wall 621b. According to an embodiment, the (2-2)^{th} side wall 621b and the (2-3)^{th} side wall 621c may be substantially perpendicular to the (2-1)^{th} side wall 621a. According to an embodiment, the second plate 621, the (2-1)^{th} side wall 621a, the (2-2)^{th} side wall 621b, and the (2-3)^{th} side wall 621c may have a shape opened on one side (e.g., the front surface) to accommodate (or surround) at least a portion of the first housing 601. For example, the first housing 601 may be coupled to the second housing 602 while being at least partially surrounded by the same and may slide in a direction parallel to the first surface F1 or the second surface F2 (e.g., direction ①) while being guided by the second housing 602. According to another embodiment, unlike the illustrated structure, the first housing 601 (e.g., the (1-2)^{th} side wall 611b and the (1-1)^{th} side wall 611a) may accommodate at least a portion of the second housing 602, and the second housing 602 may slide relative to the first housing 601 while being guided by the (1-2)^{th} side wall 611b and the (1-1)^{th} side wall 611a. According to an embodiment, the second plate 621, the (2-1)^{th} side wall 621a, the (2-2)^{th} side wall 621b, and/or the (2-3)^{th} side wall 621c may be integrally configured. According to another embodiment, the second plate 621, the (2-1)^{th} side wall 621a, the (2-2)^{th} side wall 621b, and/or the (2-3)^{th} side wall 621c may be configured as separate components or structures and coupled to or assembled with each other.

According to an embodiment, the second plate 621 and/or the (2-1)^{th} side wall 621a may cover at least a portion of the display 603. For example, at least a portion of the display 603 (e.g., the second display area A2) may be accommodated inside the first housing 601 and/or the second housing 602, and the second plate 621 and/or the (2-1)^{th} side wall 621a may cover a portion of the display 603 (e.g., the second display area A2) accommodated inside the second housing 602.

According an embodiment, the first hosing 601 may be movable in a first direction (e.g., the direction ①) parallel to the (2-2)^{th} side wall 621b or the (2-3)^{th} side wall 621c to the opened state or the closed state relative to the second housing 602, and the first housing 601 may be movable to be located at a first distance from the (2-1)^{th} side wall 621a in the closed state and at a second distance, which is greater than the first distance, from the (2-1)^{th} side wall 621a in the opened state. In some embodiments, when closed, the first housing 601 may be partially surrounded by the (2-1)^{th} side wall 621a.

According to an embodiment, the electronic device 600 may include a display 603, a key input device 641, a connector hole 643, audio modules 647a and 647b, or camera modules 649a and 649b. Although not illustrated, the electronic device 600 may further include an indicator (e.g., an LED device) or various sensor modules.

According to an embodiment, the display 603 may include a first display area A1 and a second display area A2. According to an embodiment, the first display area A1 may be disposed on the second housing 602 and/or the first housing 601. The second display area A2 may extend from the first display area A1, and, depending on the sliding of the first housing 601, may be inserted or accommodated into the interior of the first housing 601 and/or the second housing 602 (e.g., a structure) or exposed to the exterior of the first housing 601 and/or the second housing 602. A portion of the first housing 601 (e.g., the first surface F1) may at least partially overlap the second housing 602 in the closed state, and may support at least a portion of the first display area A1 and/or at least a portion of the second display area A2 in the opened state.

According to an embodiment, the second display area A2 may be moved substantially under the guidance of an area of the first housing 601 and may be accommodated into the interior of the first housing 601, the interior of the second housing 602, and/or the space formed between the first housing 601 and the second housing 602 or may be exposed to the exterior. According to an embodiment, the second display area A2 may be moved based on the sliding of the first housing 601 in the first direction (e.g., the direction of arrow ①). For example, while the first housing 601 is sliding, a portion of the second display area A2 may be transformed into a curved shape in the portion corresponding to a curved surface 650 of the first housing 601, and may be accommodated into the interior of the first housing 601 and/or the second housing 602 or moved to the exterior of the first housing 601 and/or the second housing 602.

According to an embodiment, when viewed from above the first plate 611 (e.g., the slide plate), if the first housing 601 moves from the closed state to the opened state, the second display area A2 may form a substantially flat surface with the first display area A1 while being gradually exposed to the exterior of the first housing 601 and/or the second housing 602. The display 603 may be coupled to or arranged adjacent to a touch detection circuit, a pressure sensor configured to measure a touch intensity (pressure), and/or a digitizer configured to detect a magnetic field-type stylus pen. In an embodiment, the second display area A2 may be at least partially accommodated into the interior of the first housing 601 and/or the second housing 602, and even in the state illustrated in FIG. 17 (e.g., the closed state), a portion of the second display area A2 may be visually exposed to the exterior. According to an embodiment, irrespective of the closed state or the opened state, a portion of the exposed second display area A2 may be located on a portion of the first housing, and at a position corresponding to the curved surface 650, a portion of the second display area A2 may maintain the curved shape.

Although not illustrated, the electronic device 600 may include at least one actuating device (e.g., a spring). The actuating device, such as a spring, may connect the first housing 601 (e.g., the first plate 611) and the second housing 602 (e.g., the second plate 621) and provide a driving force for sliding the first housing 601. In the embodiment(s) disclosed herein, the electronic device 600 may provide a driving force for sliding motion using a driving motor, in which case the actuating device, such as a spring, may be omitted.

According to one embodiment, the key input device 641 may be located in an area of the first housing 601 and/or the second housing 602. Depending on the external appearance and use state, the electronic device 600 may be designed such that the illustrated key input devices 641 are omitted or one or more additional key input devices are included. According to an embodiment, the electronic device 600 may include key input devices (not illustrated), such as a home key button or touch pads arranged around the home key button. According to another embodiment, at least some of the key input devices 641 may be disposed on the (2-1)^{th} side wall 621a, the (2-2)^{th} side wall 621b, or the (2-3)^{th} side wall 621c of the second housing 602.

According to an embodiment, the connector hole 643 may be omitted in some embodiments and may accommodate a connector (e.g., a USB connector) for transmitting/receiving power and/or data to/from an external electronic device. Although not illustrated, the electronic device 600 may include a plurality of connector holes 643, and some of the connector holes 643 may function as connector holes for transmitting/receiving audio signals to/from an external electronic device. In the illustrated embodiment, the connector hole 643 is arranged in the (2-3)^{th} side wall 621c, but the disclosure is not limited thereto. The connector hole 643 or another connector hole (not illustrated) may be arranged in the (2-1)^{th} side wall 621a or the (2-2)^{th} side wall 621b.

According to an embodiment, the audio modules 647a and 647b may include one or more speaker holes 647a or one or more microphone holes 647b. One of the speaker holes 647a may be provided as a receiver hole for a voice call, and another one may be provided as an external speaker hole. The electronic device 600 may include a microphone configured to acquire sound, and the microphone may acquire sound outside the electronic device 600 through the microphone holes 647b. According to an embodiment, the electronic device 600 may include a plurality of microphones in order to detect the direction of sound. According to an embodiment, the electronic device 600 may include an audio module in which the speaker holes 647a and the microphone holes 647b are implemented as a single hole, or a speaker in which the speaker holes 647a are excluded (e.g., a piezo speaker).

According an embodiment, the camera modules 649a and 649b may include a first camera module 649a and a second camera module 649b. The second camera module 649b may be located in the first housing 601 and may capture an image of a subject in a direction opposite to the first display area A1 of the display 603. The electronic device 600 may include a plurality of camera modules 649a and 649b. For example, the electronic device 600 may include at least one of a wide-angle camera, a telephoto camera, and a close-up camera. In some embodiments, the electronic device 101 may include an infrared projector and/or an infrared receiver to measure the distance to a subject. The camera modules 649a and 649b may include one or more lenses, an image sensor, and/or an image signal processor. The first camera module 649a may be arranged to be oriented in the same direction as the display 603. For example, the first camera module 649a may be arranged around the first display area A1 or in an area overlapping the display 603, and may photograph a subject through the display 603 when arranged in the area overlapping the display 603. According to an embodiment, the first camera module 649a may include an under-display camera (UDC) which may be hidden without being visually exposed in a screen display area (e.g., the first display area A1).

According to an embodiment, an indicator (not illustrated) of the electronic device 600 may be disposed on the first housing 601 or the second housing 602, and may include a light-emitting diode to provide state information of the electronic device 600 as a visual signal. A sensor module (not illustrated) of the electronic device 600 may generate an electrical signal or a data value corresponding to an internal operating status of the electronic device 600 or an external environmental status. The sensor module may include, for example, a proximity sensor, a fingerprint sensor, or a biometric sensor (e.g., an iris/face recognition sensor or an HRM sensor). In another embodiment, the sensor module may further include at least one of, for example, a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor.

According to an embodiment, the electronic device 600 may include one or more antennas 309 arranged below the display 603. For example, the antennas 309 may be arranged in the second housing 602 and may transmit and receive wireless signals through a portion of the display 603. In an embodiment, as the first housing 601 or the display 603 moves in the direction of arrow ①, the position of the display 603 overlapping the antenna 309 may change. According to the embodiment(s) of the disclosure, in a structure in which the display 603 moves relative to the antenna 309, the display 603 may include a plurality of transmissive areas (e.g., the transmissive areas TA in FIG. 6). Hereinafter, among the plurality of transmissive areas, the area overlapping the antennas 309 in the closed state is defined as a 'first active area AA1', and the area overlapping the antennas 309 in the opened state is defined as a 'fourth active area AA4'.

According to an embodiment, the first active area AA1 and the fourth active area AA4 in FIG. 17 or FIG. 18 may be substantially the same as the first active area AA1 in FIG. 10, although there is a difference in position. When the first active area AA1 and the fourth active area AA4 in FIG. 17 or FIG. 18 include control lines extending in the horizontal direction (e.g., the first control lines 333a in FIG. 10) and do not include control lines extending in the vertical direction (e.g., the second control lines 333b in FIG. 10), the antennas 309 in FIG. 17 or FIG. 18 may be configured to conduct wireless communication using vertically polarized waves and not to substantially radiate horizontally polarized waves.

According to an embodiment, in the closed state, the antennas 309 may be arranged to overlap the first active area AA1, thereby conducting wireless communication through a portion of the display 603 (e.g., the first active area AA1). When the first active area AA1 is implemented to transmit a wireless signal of a predetermined polarization component, the antennas 309 may be configured to radiate the corresponding polarization component and may not substantially radiate a wireless signal of another polarization component. In an embodiment, in the opened state, the antennas 309 may be arranged to overlap the fourth active area AA4, thereby conducting wireless communication through a portion of the display 603 (e.g., the fourth active area AA4). In an embodiment, the polarization component passing through the fourth active area AA4 may be substantially the same as the polarization component passing through the first active area AA1. For example, even if the display 603 moves or is transformed relative to the second housing 602, the antenna 309 may be provided with a stable wireless communication environment.

Although not illustrated, in a structure in which the operating environment changes due to the relative movement of the housings 601 and 602, one first active area AA1 or one fourth active area AA4 may be provided and arranged to overlap the antenna 309. For example, in the structure illustrated in FIG. 18, the first active area AA1 or the fourth active area AA4 may further extend in the direction of arrow ①. In this case, one of the first active area AA1 and the fourth active area AA4 is configured to transmit a predetermined polarization component, and the other active area may be omitted. When one of the first active area AA1 and the fourth active area AA4 has a structure extending in the direction of arrow ①, the antenna 309 may be provided with a stable wireless communication environment not only in the closed state of FIG. 17 and the opened state of FIG. 18, but also in the operation in which the electronic device 600 is transformed between the opened state and the closed state. The number and size of first active areas AA1 and fourth active areas AA4 can be appropriately selected depending on the specifications required for the electronic device 600. For example, the number and size of first active areas AA1 (or fourth active areas AA4) can be appropriately selected in consideration of the wireless communication environment and screen quality.

FIG. 19 is a view illustrating the arrangement of an antenna under a display of an electronic device according to an embodiment of the disclosure. FIG. 20 is a view illustrating the arrangement of an antenna under a display of an electronic device according to an embodiment of the disclosure.

Referring to FIGS. 19 and 20, the first antenna 309 (e.g., the antenna 309 in FIG. 6 or FIG. 7) may be disposed under the display 330 and adjacent to the sensor 707 or 807. For example, the first antenna 309 may be disposed within a certain distance of the sensor 707 or 807. For example, the first antenna may be disposed within 2 cm, or 1 cm, or 0.5 cm, or 0.1 cm of the sensor 707 or 807. In an embodiment, the sensor 707 or 807 may include a camera, a proximity sensor, an illuminance sensor, a fingerprint recognition sensor, a facial recognition sensor, and/or an iris recognition sensor. In an embodiment, a second antenna may be additionally provided or may replace the sensor 707 or 807. The first antenna 309 and the sensor 707 or 807 (or the second antenna) may be disposed under the display 330 to overlap different portions of the display 330 without overlapping each other. When the first antenna 309 and the sensor 707 or 807 (or the second antenna) are provided, the display 330 may include a transmissive area (e.g., the transmissive area TA in FIG. 6) corresponding to the first antenna 309 and/or a transmissive area corresponding to the sensor 707 or 807) (or the second antenna). The transmissive area may be implemented, for example, by one of the above-described first active area AA1 and/or third active area AA3. The embodiment of FIG. 19 exemplifies a structure in which the first antenna 309 and the sensor 707 or 807 (or the second antenna) are arranged to overlap one transmissive area, and the embodiment of FIG. 20 exemplifies a structure in which multiple transmissive areas corresponding to the first antenna 309 and the sensor 707 or 807 (or the second antenna) are provided. The number and size of transmissive areas may be appropriately selected in consideration of the image quality of the display 330, the operating environment of the first antenna 309, and/or the operating environment of the sensor 707 or 807 (or the second antenna).

In the embodiment illustrated in FIG. 19, the first antenna 309 and the sensor 707 (or the second antenna) may be arranged to overlap different portions of the above-described first active area AA1. When the second antenna is arranged to replace the sensor 707, the second antenna may transmit and receive wireless signals having substantially the same polarization component as the first antenna 309. In an embodiment, the first antenna 309 and the second antenna may conduct wireless communication through different portions of the first active area AA1. When phase difference feeding is provided to at least one of the first antenna 309 and the second antenna, for example, when a beam steering operation is performed, some of the signals transmitted and received through the first antenna 309 and some of the signals transmitted and received through the second antenna may pass through substantially the same portion within the first active area AA1.

In the embodiment illustrated in FIG. 20, the first antenna 309 may be arranged to overlap the above-described first active area AA1, and the sensor 807 (or the second antenna) may be arranged to overlap a fifth active area AA5 different from the first active area AA1. The fifth active area AA5 may be substantially the same as, for example, either the first active area AA1 or the third active area AA3 of FIG. 11, and may be arranged adjacent to the first active area AA1 of FIG. 20. In an embodiment, the polarization components passing through the first active area AA1 and the fifth active area AA5 may be different from each other, and a second antenna, which replaces the sensor 807, may be arranged in the fifth active area AA5. For example, the second antenna, which replaces the sensor 807, may be arranged to overlap the fifth active area AA5, and may transmit and receive signals having a different polarization component from the first antenna 309. In an embodiment, the polarization components passing through the first active area AA1 and the fifth active area AA5 may be substantially the same, and in this case, the first antenna 309 and the second antenna may conduct wireless communication using the same polarization component. In an embodiment, when a sensor 807 other than the second antenna is arranged, the fifth active area AA5 may be substantially identical to, for example, the optical hole 539a of FIG. 15 or the notch area 539b of FIG. 16.

FIG. 21 is a view illustrating the arrangement of an antenna in an electronic device according to an embodiment of the disclosure.

Referring to FIG. 21, an antenna 909 (e.g., the antenna 309 in FIG. 7) may be arranged at least partially in a space provided by a display 930 (e.g., the display 330 in FIG. 7). For example, a space substantially surrounded by (or substantially defined by) the display 930 may be implemented by removing a portion of the wiring layer WL, a portion of the light-emitting layer PL, and/or a portion of the encapsulation layer EL in FIG. 7, and at least a portion of the antenna 909 may be accommodated in this space. The display 930 and/or the antenna 909 may be substantially isolated from the external space by a window plate 920 (e.g., the front surface plate 220 in FIG. 4 or FIG. 5), and may be visually exposed to the external space through the window plate 920. In an embodiment, the antenna 909 may be visually concealed by providing a paint layer (not illustrated) on the window plate 920.

In an embodiment, although not provided with a reference numeral, an opening area corresponding to the antenna 909 may be provided by the first support member 211 (e.g., the first support member 211 in FIG. 4). In an embodiment, the antenna 909 may be electrically connected to a main circuit board 940 (e.g., the printed circuit board 240 in FIG. 4 or FIG. 5) through the opening area. In the illustrated embodiment, the main circuit board 940 may be arranged to directly face the antenna 909 through the opening area provided in the first support member 211. For example, the antenna 909 may be electrically connected to the main circuit board 940 by being placed on (or directly mounted on) the main circuit board 940. In an embodiment, when the main circuit board 940 is defined as being disposed on the bottom surface of the first support member 211, the display 930 may be understood as being disposed on the top surface of the first support member 211. In this case, the antenna 909 may be understood as being disposed on the top surface of the first support member 211 through the opening area of the first support member 211 while being directly mounted on the main circuit board 940. In an embodiment, the display 930 and/or the antenna 909 may be described as being accommodated or protected in the space between the first support member 211 and the window plate 920, and the main circuit board 940 may be described as being accommodated or protected in the space between the first support member 211 and the rear surface plate 280 (e.g., the rear surface plate 280 in FIG. 4 or FIG. 5).

As described above, an electronic device according to an embodiment(s) of the disclosure (e.g., the electronic device 1000, 100, 200, 300, 400, 500a, 500b, or 600 in FIGS. 1 to 5 and/or 12 to 18) may include an antenna (e.g., the antenna module 1097 in FIG. 1 or the antenna 291 or 309 in FIGS. 5 to 7) that conducts wireless communication through the display by using the arrangement of control lines (the control lines 333; 333a and 333b in FIGS. 6 to 11) of a display (e.g., the display module 1060 in FIG. 1 or the display 330 in FIGS. 4 to 16), and polarization components. For example, by including an antenna that conducts wireless communication through the display, it may be easy to secure omnidirectionality in wireless communication. This allows for improved design freedom in antenna arrangement in a miniaturized electronic device and creates a better wireless communication environment.

The effects capable of being obtained by the disclosure are not limited to those described above, and other effects not described above may be clearly understood by a person ordinarily skilled in the art to which the disclosure belongs from the descriptions of the above-described embodiments.

According to an embodiment of the disclosure, an electronic device (e.g., the electronic device 1000, 100, 200, 300, 400, 500a, 500b, or 600 in FIGS. 1 to 5, and/or FIGS. 12 to 18) may include a wireless communication circuit (e.g., the communication module 1090 or the wireless communication module 1092 in FIG. 1) accommodated in the electronic device, a display (e.g., the display module 1060 in FIG. 1 or the display 330 in FIGS. 4 to 16) accommodated in the electronic device, and including an active display area including a plurality of pixels, wherein the active display area at least partially includes an area (hereinafter, a 'first active area') (e.g., the first active area AA1 in FIG. 10 or FIG. 11) including at least one first control line (e.g., the first control line 333a in FIG. 6 or FIG. 10) for driving some of the plurality pixels and extending along a first direction (e.g., the first direction D1 in FIG. 10) while not including at least one second control line (e.g., the second control line 333b in FIG. 6 or FIG. 10) extending along a second direction (e.g., the second direction D2 in FIG. 10) substantially perpendicular to the first direction, and an antenna radiator (e.g., the antenna module 1097 in FIG. 1, the antennas 291 and 309 in FIGS. 5 to 7, or the antenna radiator 393 in FIG. 7) at least partially disposed under the first active area of the display and operatively connected to the wireless communication circuit. In an embodiment, the antenna radiator may be configured to radiate signals, received from the wireless communication circuit, substantially through the first active area in a second polarization corresponding to the second direction rather than in a first polarization corresponding to the first direction. In an embodiment, signals being radiated in the second polarization may correspond to signals received from the wireless communication circuit.

According to an embodiment of the disclosure, an electronic device (e.g., the electronic device 1000, 100, 200, 300, 400, 500a, 500b, or 600 in FIGS. 1 to 5, and/or FIGS. 12 to 18) may include a wireless communication circuit (e.g., the communication module 1090 or the wireless communication module 1092 in FIG. 1) accommodated in the electronic device, a display (e.g., the display module 1060 in FIG. 1 or the display 330 in FIGS. 4 to 16) accommodated in the electronic device and including an active display area including a plurality of pixels, wherein the active display area includes at least one first active area (e.g., the first active area AA1 in FIG. 10 or FIG. 11) including at least one first control line (e.g., the first control line 333a in FIG. 6 or FIG. 10) extending along a first direction (e.g., the first direction D1 in FIG. 10) configured to drive some of the plurality of pixels while not including at least one second control line (e.g., the second control line 333b in FIG. 6 or FIG. 10) extending along a second direction (e.g., the second direction D2 in FIG. 10) substantially perpendicular to the first direction, and an antenna radiator (e.g., the antenna module 1097 in FIG. 1, the antenna module 291 or 309 in FIGS. 5 to 7, or the antenna radiator 393 in FIG. 7) disposed under the display to at least partially overlap the at least one first active area and operatively connected to the wireless communication circuit. In an embodiment, the antenna radiator may be configured to radiate signals substantially through the at least one first active area in a second polarization corresponding to the second direction rather than in a first polarization corresponding to the first direction. In an embodiment, signals being radiated in the second polarization may correspond to signals received from the wireless communication circuit.

According to an embodiment, the signals corresponding to the first polarization may not be radiated through the first active area.

According to an embodiment, the antenna radiator may include a first antenna radiator (e.g., one of the antenna radiators 393 in FIG. 7) and a second antenna radiator (e.g., one of the antenna radiators 393 in FIG. 7), and the first antenna radiator and the second antenna radiator are configured to radiate the second polarized wave.

According to an embodiment, in the electronic device, the display may further include at least one third control line (e.g., the third control line 333c in FIG. 14) corresponding to pixels of the at least one first active area and extending in the first direction.

According to an embodiment, a first portion (e.g., the first portion 31a in FIG. 14) of the at least one third control line may extend to substantially surround at least one side of a first pixel among the pixels of the at least one first active area.

According to an embodiment, a second portion (e.g., the second portion 31b in FIG. 14) of the at least one third control line may protrude in the second direction between the first pixel among the pixels of the first active area and a second pixel adjacent to the first pixel.

According to an embodiment, a third portion (e.g., the third portion 31c in FIG. 14) of the at least one third control line may protrude in the second direction between the second pixel among the pixels of the at least one first active area and a third pixel adjacent to the second pixel.

According to an embodiment, the at least one third control line may be configured to provide data to the first pixel through the at least one side of the first pixel.

According to an embodiment, the display may further include a second active area (e.g., the second active area AA2 in FIG. 10), which is another portion of the active display area, including at least one of the first control line for driving some other pixels among the plurality pixels and at least one of the second control line for driving the some other pixels among the plurality pixels.

According to an embodiment, signals corresponding to both the first polarization and the second polarization are not radiated through the second active area.

According to an embodiment, the electronic device may further include a first control unit (e.g., the first control unit 339a in FIG. 12) configured to control operation of pixels of the at least one first active area among the plurality of pixels, and a second control unit (e.g., the control unit 339b in FIG. 12) configured to control operation of pixels of the second active area among the plurality of pixels.

According to an embodiment, the distribution density of pixels in the second active area may be higher than the distribution density of pixels in the at least one first active area.

According to an embodiment, in the at least one first active area, the interval between two adjacent pixels may be 60 µm or more and 160 µm or less.

According to an embodiment, the electronic device may further include a sensor (e.g., the sensor 707 in FIG. 19) arranged below the display so that at least a portion of the sensor overlaps the at least one first active area but does not overlap the antenna radiator.

According to an embodiment, the display may further include a third active area (e.g., the third active area in FIG. AA3), which is another portion of the active display area, including the at least one second control line for driving at least another portion of the plurality pixels while not including the at least one first control line. In an embodiment, the electronic device may further include a second antenna radiator disposed under the display to at least partially overlap with the third active area and operatively connected to the wireless communication circuit (e.g., an antenna that replaces the sensor 807 in FIG. 20). In an embodiment, the second antenna radiator may be configured to radiate signals in a first polarization corresponding to the first direction substantially through the third active area with respect to signals received from the wireless communication circuit rather than in the second polarization.

Signals corresponding to the second polarization may not be radiated through the third active area.

According to an embodiment of the disclosure, an electronic device (e.g., the electronic device 1000, 100, 200, 300, 400, 500a, 500b, or 600 in FIGS. 1 to 5, and/or FIGS. 12 to 18) may include a housing (e.g., the housing 201 in FIG. 4 or FIG. 5), a wireless communication circuit (e.g., the communication module 1090 or a wireless communication module 1092 in FIG. 1) accommodated in the housing, a display accommodated in the housing (e.g., a display module (e.g., the display module 1060 in FIG. 1 or the display 330 in FIGS. 4 to 16), and an antenna radiator (e.g., the antenna module 1097 in FIG. 1, the antenna 291 or 309 in FIGS. 5 to 7, or the antenna radiator 393 in FIG. 7) disposed under the display to at least partially overlap the at least one first active area and operatively connected to the wireless communication circuit. In an embodiment, the display may include first control lines (e.g., the first control lines 333a in FIG. 6 or FIG. 10) corresponding to at least some of a plurality of pixels (e.g., the pixels 331 in FIG. 6) and extending in a first direction (e.g., the first direction D1 in FIG. 10), second control lines (e.g., the second control lines 333b in FIG. 6 or FIG. 10) corresponding to at least some of the plurality of pixels and extending in a second direction (e.g., the second direction D2 in FIG. 10) intersecting the first direction, and at least one first active area (e.g., the first active area AA1 in FIG. 10 or FIG. 11) in which the first control lines are arranged but the second control lines are not arranged. In an embodiment, the antenna radiator may be configured to radiate signals, received from the wireless communication circuit, substantially through the at least one first active area in a second polarization corresponding to the second direction rather than in a first polarization corresponding to the first direction.

According to an embodiment, the antenna radiator may include a first antenna radiator (e.g., one of the antenna radiators 393 in FIG. 7) and a second antenna radiator (e.g., one of the antenna radiators 393 in FIG. 7). In an embodiment, the first antenna radiator and the second antenna radiator are configured to radiate the second polarized wave.

According to an embodiment, the display may further include at least one third control line (e.g., the third control line 333c in FIG. 14) corresponding to pixels of the at least one first active area and extending in the first direction.

According to an embodiment, a first portion (e.g., the first portion 31a in FIG. 14) of the at least one third control line may extend to substantially surround at least one side of a first pixel among the pixels of the at least one first active area.

According to an embodiment, a second portion (e.g., the second portion 31b in FIG. 14) of the at least one third control line may protrude in the second direction between the first pixel among the pixels of the at least one first active area and a second pixel adjacent to the first pixel.

According to an embodiment, a third portion (e.g., the third portion 31c in FIG. 14) of the third control line may protrude in the second direction between the second pixel among the pixels of the at least one first active area and a third pixel adjacent to the second pixel.

According to an embodiment, the at least one third control line may be configured to provide data to the first pixel through the at least one side of the first pixel.

According to an embodiment, the display may further include a second active area (e.g., the second active area AA2 in FIG. 10) in which at least some others of the first control lines and at least some of the second control lines are arranged together. In an embodiment, the above antenna radiator may be arranged not to overlap the second active area.

According to an embodiment, the electronic device may further include a first control unit (e.g., the first control unit 339a in FIG. 12) configured to control operation of pixels of the at least one first active area among the plurality of pixels, and a second control unit (e.g., the second control unit 339b in FIG. 12) configured to control operation of pixels of the second active area among the plurality of pixels.

According to an embodiment, the distribution density of pixels in the second active area may be higher than the distribution density of pixels in the at least one first active area.

According to an embodiment, in the at least one first active area, the interval between two adjacent pixels may be 60 µm or more and 160 µm or less.

According to an embodiment, the electronic device may further include a sensor (e.g., the sensor 707 in FIG. 19) arranged below the display so that at least a portion of the sensor overlaps the first active area but does not overlap the antenna radiator.

According to an embodiment, the display may further include at least one third active area (e.g., the third active area AA3 in FIG. 11) in which some of the second control lines are arranged but the first control lines are not arranged. In an embodiment, when the display includes the third active area, the electronic device may further include a second antenna radiator (e.g., an antenna that replaces the sensor 807 in FIG. 20) disposed under the display to at least partially overlap the third active area and operatively connected to the wireless communication circuit.

According to an embodiment, the second antenna radiator is configured to radiate signals, received from the wireless communication circuit, in the first polarization corresponding to the first direction substantially through the third active area rather than in the second polarization corresponding to the second direction.

According to an embodiment of the disclosure, an electronic device (e.g., the electronic device 1000, 100, 200, 300, 400, 500a, 500b, or 600 in FIGS. 1 to 5, and/or FIGS. 12 to 18) may include a wireless communication circuit (e.g., the communication module 1090 or the wireless communication module 1092 in FIG. 1), a display (e.g., the display module 1060 in FIG. 1 or the display 330 in FIGS. 4 to 16), and an antenna radiator (e.g., the antenna module 1097 in FIG. 1, the antenna 291 or 309 in FIGS. 5 to 7 or the antenna radiator 393 in FIG. 7) disposed under the display to at least partially overlap at least one first active area (e.g., the first active area AA1 in FIG. 10 or FIG. 11) and operatively connected to the wireless communication circuit. In an embodiment, the display may include first control lines (e.g., the first control lines 333a in FIG. 6 or FIG. 10) corresponding to at least some of the plurality of pixels and extending along a first direction (e.g., the first direction D1 in FIG. 10), second control lines (e.g., the second control lines 333b in FIG. 6 or FIG. 10) corresponding to at least some of the plurality of pixels and extending in a second direction (e.g., the second direction D2 in FIG. 10) intersecting the first direction, at least one first active area in which the first control lines are arranged but the second control lines are not arranged, and a second active area (e.g., the second active area AA2 in FIG. 10) in which the first control lines and the second control lines are arranged together. In an embodiment, the antenna radiator may be configured to receive a signal from the wireless communication circuit and to transmit and receive a wireless signal having a polarization component that penetrates the at least one first active area.

According to an embodiment, the electronic device may further include a first control unit (e.g., the first control unit 339a in FIG. 12) configured to control operation of pixels of the at least one first active area among the plurality of pixels, and a second control unit (e.g., the second control unit 339b in FIG. 12) configured to control operation of pixels of the second active area among the plurality of pixels.

According to an embodiment, the distribution density of pixels in the second active area may be higher than the distribution density of pixels in the at least one first active area.

According to an embodiment, the electronic device may further include an optical hole (e.g., the optical hole 539a in FIG. 15) adjacent to a first section of an edge of the display. In an embodiment, the at least one first active area may be at least partially disposed between the optical hole and the first section.

According to an embodiment, the electronic device may further include a sensor (e.g., the sensor 707 in FIG. 19) arranged below the display so that at least a portion of the sensor overlaps the at least one first active area but does not overlap the antenna radiator.

According to an embodiment, the antenna radiator may include a first antenna radiator (e.g., one of the antenna radiators 393 in FIG. 7) and a second antenna radiator (e.g., one of the antenna radiators 393 in FIG. 7). In an embodiment, the wireless communication circuit may be configured to provide a phase difference signal to the first antenna radiator and the second antenna radiator.

Although the disclosure has been described with reference to an embodiment as an example, it is to be understood that the embodiment is intended to be exemplary and is not limiting the disclosure. It will be apparent to those skilled in the art that various changes can be made in form and detail without departing from the overall scope of the disclosure, including the appended claims and equivalents to the same. For example, in the above-described embodiments, the antenna is described as having a configuration including one or more antenna radiators, but the embodiments of the disclosure are not limited thereto. The antenna may include a single antenna radiator. For example, the above-described antenna may be implemented as an antenna radiator itself. In an embodiment, a plurality of antenna radiators may be arranged in one antenna. In this case, the plurality of antenna radiators may conduct wireless communication in different frequency bands, and/or the plurality of antenna radiators may conduct wireless communication in the same frequency band through phase difference feeding. When a plurality of antenna radiators are arranged in one antenna, the plurality of antenna radiators may be configured to transmit and receive wireless signals having substantially the same polarization component.

In a first example, there is provided an electronic device (e.g. electronic device 1000; 100; 200; 300; 400; 500a; 500b; 600), comprising: a wireless communication circuit (e.g. wireless communication circuit 1090, 1092) disposed in the electronic device; a display (e.g. display 230, 330) disposed in the electronic device, and including an active display area comprising a plurality of pixels, wherein the active display area at least partially includes an area (hereinafter, 'a/the first active area') including at least one first control line for driving a portion of the plurality pixels and extending along a first direction (e.g. first direction D1) while not including at least one second control line extending along a second direction substantially orthogonal to the first direction; and an antenna radiator (e.g. antenna radiator 309, 393) at least partially disposed under the first active area of the display and operatively connected to the wireless communication circuit, wherein the antenna radiator is configured to radiate signals substantially through the first active area in a second polarization corresponding to the second direction rather than in a first polarization corresponding to the first direction, and wherein signals being radiated in the second polarization correspond to signals received from the wireless communication circuit.

In a second example, there is provided the electronic device of the first example, wherein the signals corresponding to the first polarization corresponding to the first direction are not radiated through the first active area.

In a third example, there is provided the electronic device of any one of the first to second examples, wherein the antenna radiator includes a first antenna radiator and a second antenna radiator, and wherein the first antenna radiator and the second antenna radiator are configured to radiate the second polarized wave.

In a fourth example, there is provided the electronic device of any one of the first to third examples, wherein the display further includes at least one third control line (e.g. third control line 333c) corresponding to pixels of the first active area and extending in the first direction.

In a fifth example, there is provided the electronic device of the fourth example, wherein a first portion (e.g. first portion 31a) of the at least one third control line extends to substantially surround at least one side of a first pixel among the pixels of the first active area.

In a sixth example, there is provided the electronic device of the fifth example, wherein a second portion (e.g. second portion 31b) of the at least one third control line protrudes in the second direction between the first pixel among the pixels of the first active area and a second pixel adjacent to the first pixel.

In a seventh example, there is provided the electronic device of the sixth example, wherein a third portion (e.g. third portion 31c) of the third control line protrudes in the second direction between the second pixel among the pixels of the first active area and a third pixel adjacent to the second pixel.

In an eighth example, there is provided the electronic device of any one of the fifth to seventh examples, wherein the at least one third control line is configured to provide data to the first pixel through the at least one side of the first pixel.

In a ninth example, there is provided the electronic device of any one of the first to eighth examples, wherein the display further includes a second active area (e.g. second active area AA2), which is another portion of the active display area of the display, including at least one of the first control line for driving the another portion of the plurality pixels and at least one of the second control line for driving the another portion of the plurality pixels.

In a tenth example, there is provided the electronic device of the ninth example, wherein signals corresponding to both of the first polarization and the second polarization are not radiated through the second active area.

In an eleventh example, there is provided the electronic device of any one of the ninth to tenth examples, further comprising: a first control unit (e.g. first control unit 339a) configured to control operation of pixels of the first active area among the plurality of pixels; and a second control unit (e.g. second control unit 339b) configured to control operation of pixels of the second active area among the plurality of pixels.

In a twelfth example, there is provided the electronic device of any one of the ninth to eleventh examples, wherein a distribution density of pixels in the second active area is higher than a distribution density of pixels in the first active area.

In a thirteenth example, there is provided the electronic device of any one of the ninth to twelfth examples, wherein in the first active area, an interval between two adjacent pixels is 60 µm or more and 160 µm or less.

In a fourteenth example, there is provided the electronic device of any one of the first to thirteenth examples, further comprising: a sensor (e.g. sensor 707) disposed below the display so that at least a portion of the sensor overlaps the first active area but does not overlap the antenna radiator.

In a fifteenth example, there is provided the electronic device of any one of the first to fourteenth examples, wherein the display further includes a third active area (e.g. third active area AA3), which is another portion of the active display area of the display, including the at least one second control line for driving at least another portion of the plurality pixels while not including the at least one first control line, and wherein the electronic device further includes a second antenna radiator disposed under the display to at least partially overlap with the third active area of the active display area and operatively connected to the wireless communication circuit, wherein the second antenna radiator is configured to radiate signals in a first polarization corresponding to the first direction substantially through the third active area with respect to signals received from the wireless communication circuit rather than in the second polarization.

In a sixteenth example, there is provided the electronic device of any one of the first to fifteenth examples, wherein signals corresponding to the second polarization are not radiated through the second active area.

In a seventeenth example, there is provided an electronic device (e.g. electronic device 1000; 100; 200; 300; 400; 500a; 500b; 600) comprising: a wireless communication circuit (e.g. wireless communication circuit 1090, 1092); a display (e.g. display 230; 330) including first control lines (e.g. first control lines 333a) corresponding to at least some of a plurality of pixels and extending in a first direction (e.g. first direction D1), second control lines (e.g. second control lines 333b) corresponding to at least some of the plurality of pixels and extending in a second direction (e.g. second direction D2) intersecting the first direction, at least one first active area (e.g. first active area AA1) in which the first control lines are arranged but the second control lines are not arranged, and a second active area (e.g. second active area AA2) in which the first control lines and the second control lines are arranged together; and an antenna radiator (e.g. antenna radiator 309, 393) disposed under the display to at least partially overlap the at least one first active area and operatively connected to the wireless communication circuit, wherein the antenna radiator is configured to receive signals from the wireless communication circuit and to transmit and receive a wireless signal with a polarization component passing through the at least one first active area.

In an eighteenth example, there is provided the electronic device of the seventeenth example, further comprising: a first control unit (e.g. first control unit 339a) configured to control operation of pixels of the at least one first active area among the plurality of pixels; and a second control unit (e.g. second control unit 339b) configured to control operation of pixels of the second active area among the plurality of pixels.

In a nineteenth example, there is provided the electronic device of one of the seventeenth to eighteenth examples, wherein a distribution density of pixels in the second active area is higher than a distribution density of pixels in the at least one first active area.

In a twentieth example, there is provided the electronic device of one of the seventeenth to nineteenth examples, wherein the antenna radiator includes a first antenna radiator and a second antenna radiator, and wherein the wireless communication circuit is configured to provide a phase-difference signal to the first antenna radiator and the second antenna radiator.

In a twenty-first example, there is provided an electronic device (e.g. 1000; 100; 200; 300; 400; 500a; 500b; 600) comprising: a wireless communication circuit (e.g. 1090, 1092); a display (e.g. 230; 330) including first pixel control lines (e.g. 333a) extending in a first direction (e.g. D1), second pixel control lines (e.g. 333b) extending in a second direction (e.g. D2) intersecting the first direction, at least one first active area (e.g. AA1) comprising a first set of pixels, and a second active area (e.g. AA2) comprising a second set of pixels; and an antenna radiator (e.g. 309, 393) disposed under the display to at least partially overlap the at least one first active area and operatively connected to the wireless communication circuit; wherein at least one of the first pixel control lines is arranged in the at least one first active area but none of the second pixel control lines are arranged in the at least one first active area, wherein at least one of the first pixel control lines is arranged in the second active area and at least one of the second pixel control lines is arranged in the second active area, wherein the antenna radiator is configured to receive signals from the wireless communication circuit and to transmit and/or receive wireless signals with a polarization component passing through the at least one first active area.

In a twenty-second example, there is provided the electronic device of the twenty-first example, wherein the wireless signals with a polarization component passing through the at least one first active area comprise signals with a second polarization corresponding to the second direction.

In a twenty-third example, there is provided the electronic device of the twenty-first or twenty-second example, wherein wireless signals with a first polarization corresponding to the first direction are not radiated through the at least one first active area.

In a twenty-fourth example, there is provided the electronic device of any of the twenty-first to twenty-second examples, further comprising: a first control unit (e.g. 339a) configured to control operation of pixels of the first set of pixels; and a second control unit (e.g. 339b) configured to control operation of pixels of the second set of pixels.

In a twenty-fifth example, there is provided the electronic device of any of the twenty-first to twenty-fourth examples, wherein a distribution density of pixels in the second active area is higher than a distribution density of pixels in the at least one first active area.

In a twenty-sixth example, there is provided the electronic device of any of the twenty-first to twenty-fifth examples, wherein the antenna radiator includes a first antenna radiator and a second antenna radiator, and wherein the wireless communication circuit is configured to provide a phase-difference signal to the first antenna radiator and the second antenna radiator.

In a twenty-seventh example, there is provided the electronic device of any of the twenty-first to twenty-sixth examples, wherein the display further includes at least one third pixel control line (e.g. 333c) corresponding to pixels of the first active area and extending in the first direction.

In a twenty-eighth example, there is provided the electronic device of the twenty-seventh example, wherein a first portion (e.g. 31a) of the at least one third pixel control line substantially surrounds at least one side of a first pixel among the first set of pixels.

In a twenty-ninth example, there is provided the electronic device of the twenty-eighth example, wherein a second portion (e.g. 31b) of the at least one third pixel control line protrudes in the second direction between the first pixel among the first set of pixels and a second pixel adjacent to the first pixel.

In a thirtieth example, there is provided the electronic device of the twenty-ninth example, wherein a third portion (e.g. 31c) of the third pixel control line protrudes in the second direction between the second pixel and a third pixel adjacent to the second pixel.

In a thirty-first example, there is provided the electronic device of any of the twenty-seventh to thirtieth examples, wherein the at least one third control line is configured to provide data to the first pixel through the at least one side of the first pixel.

In a thirty-second example, there is provided the electronic device of any of the twenty-first to thirty-first examples, wherein in the first active area, an interval between two adjacent pixels is 60 µm or more and 160 µm or less.

In a thirty-third example, there is provided the electronic device of any of the twenty-first to thirty-second examples, further comprising: a sensor (e.g. 707) disposed below the display so that at least a portion of the sensor overlaps the first active area but does not overlap the antenna radiator.

In a thirty-fourth example, there is provided the electronic device of any of the twenty-first to thirty-third examples, wherein the display further includes at least one third active area (e.g. AA3), which is another portion of the active display area of the display and comprises a third set of pixels, wherein at least one of the second pixel control lines is arranged in the at least one third active area but none of the first pixel control lines are arranged in the at least one third active area, wherein the electronic device further includes a second antenna radiator disposed under the display to at least partially overlap with the at least one third active area and operatively connected to the wireless communication circuit, wherein the second antenna radiator is configured to receive signals from the wireless communication circuit and to transmit and/or receive wireless signals with a polarization component passing through the at least one third active area, wherein the wireless signals with a polarization component passing through the at least one third active area comprise signals with a first polarization corresponding to the first direction.

In a thirty-fifth example, there is provided the electronic device of any of the twenty-first to thirty-fourth examples, further comprising: a first housing (e.g. 601); a second housing (e.g. 602) configured to be moveable relative to the first housing between a first position and a second position to change the size of the exposed active display area of the display, wherein the antenna radiator is arranged in the second housing; wherein the at least one first active area is disposed on the display to at least partially overlap with the antenna radiator when the second housing is in the first position such that the antenna radiator can transmit wireless signals with a polarization component passing through the at least one first active area when the second housing is in the first position, wherein the display further comprises at least one fourth active area (e.g. AA4) which is another portion of the active display area of the display and comprises a fourth set of pixels, wherein at least one of the first pixel control lines is arranged in the at least one fourth active area but none of the second pixel control lines are arranged in the at least one fourth active area, and wherein the at least one fourth active area is disposed on the display to at least partially overlap with the antenna radiator when the second housing is in the second position such that the antenna radiator transmits wireless signals with a polarization component passing through the at least one fourth active area when the second housing is in the second position.

## Claims

1. An electronic device (1000; 100; 200; 300; 400; 500a; 500b; 600) comprising:
a wireless communication circuit (1090, 1092);
a display (230; 330) including first pixel control lines (333a) extending in a first direction (D1), second pixel control lines (333b) extending in a second direction (D2) intersecting the first direction, at least one first active area (AA1) comprising a first set of pixels, and a second active area (AA2) comprising a second set of pixels; and
an antenna radiator (309, 393) disposed under the display to at least partially overlap the at least one first active area and operatively connected to the wireless communication circuit;
wherein at least one of the first pixel control lines is arranged in the at least one first active area but none of the second pixel control lines are arranged in the at least one first active area,
wherein at least one of the first pixel control lines is arranged in the second active area and at least one of the second pixel control lines is arranged in the second active area,
wherein the antenna radiator is configured to receive signals from the wireless communication circuit and to transmit and/or receive wireless signals with a polarization component passing through the at least one first active area.

2. The electronic device of claim 1, wherein the wireless signals with a polarization component passing through the at least one first active area comprise signals with a second polarization corresponding to the second direction.

3. The electronic device of claim 1 or 2,
wherein wireless signals with a first polarization corresponding to the first direction are not radiated through the at least one first active area.

4. The electronic device of any one of claims 1 to 3, further comprising:
a first control unit (339a) configured to control operation of pixels of the first set of pixels; and
a second control unit (339b) configured to control operation of pixels of the second set of pixels.

5. The electronic device of any one of claims 1 to 4,
wherein a distribution density of pixels in the second active area is higher than a distribution density of pixels in the at least one first active area.

6. The electronic device of any one of claims 1 to 5,
wherein the antenna radiator includes a first antenna radiator and a second antenna radiator, and
wherein the wireless communication circuit is configured to provide a phase-difference signal to the first antenna radiator and the second antenna radiator.

7. The electronic device of any one of claims 1 to 6,
wherein the display further includes at least one third pixel control line (333c) corresponding to pixels of the first active area and extending in the first direction.

8. The electronic device of claim 7,
wherein a first portion (31a) of the at least one third pixel control line substantially surrounds at least one side of a first pixel among the first set of pixels.

9. The electronic device of claim 8,
wherein a second portion (31b) of the at least one third pixel control line protrudes in the second direction between the first pixel among the first set of pixels and a second pixel adjacent to the first pixel.

10. The electronic device of claim 9,
wherein a third portion (31c) of the third pixel control line protrudes in the second direction between the second pixel and a third pixel adjacent to the second pixel.

11. The electronic device of any one of claims 7 to 10,
wherein the at least one third control line is configured to provide data to the first pixel through the at least one side of the first pixel.

12. The electronic device of any one of claims 1 to 11,
wherein in the first active area, an interval between two adjacent pixels is 60 µm or more and 160 µm or less.

13. The electronic device of any one of claims 1 to 12, further comprising:
a sensor (707) disposed below the display so that at least a portion of the sensor overlaps the first active area but does not overlap the antenna radiator.

14. The electronic device of any one of claims 1 to 13,
wherein the display further includes at least one third active area (AA3), which is another portion of the active display area of the display and comprises a third set of pixels,
wherein at least one of the second pixel control lines is arranged in the at least one third active area but none of the first pixel control lines are arranged in the at least one third active area,
wherein the electronic device further includes a second antenna radiator disposed under the display to at least partially overlap with the at least one third active area and operatively connected to the wireless communication circuit,
wherein the second antenna radiator is configured to receive signals from the wireless communication circuit and to transmit and/or receive wireless signals with a polarization component passing through the at least one third active area,
wherein the wireless signals with a polarization component passing through the at least one third active area comprise signals with a first polarization corresponding to the first direction.

15. The electronic device of any one of claims 1 to 14, further comprising:
a first housing (601); and
a second housing (602) configured to be moveable relative to the first housing between a first position and a second position to change the size of the exposed active display area of the display, wherein the antenna radiator is arranged in the second housing;
wherein the at least one first active area is disposed on the display to at least partially overlap with the antenna radiator when the second housing is in the first position such that the antenna radiator can transmit wireless signals with a polarization component passing through the at least one first active area when the second housing is in the first position,
wherein the display further comprises at least one fourth active area (AA4) which is another portion of the active display area of the display and comprises a fourth set of pixels,
wherein at least one of the first pixel control lines is arranged in the at least one fourth active area but none of the second pixel control lines are arranged in the at least one fourth active area, and
wherein the at least one fourth active area is disposed on the display to at least partially overlap with the antenna radiator when the second housing is in the second position such that the antenna radiator transmits wireless signals with a polarization component passing through the at least one fourth active area when the second housing is in the second position.
